(19) Europäisches Patentamt
European Patent Office
Office européen des brevets

(11) **EP 3 988 270 B1**

(12) **EUROPEAN PATENT SPECIFICATION**

(45) Date of publication and mention
of the grant of the patent:
**31.07.2024 Bulletin 2024/31**

(21) Application number: **21203629.7**

(22) Date of filing: **20.10.2021**

(51) International Patent Classification (IPC):
$B29B\ 7/72^{(2006.01)}$    $B29C\ 48/00^{(2019.01)}$
$B29C\ 48/04^{(2019.01)}$    $B29C\ 48/05^{(2019.01)}$
$B29C\ 48/255^{(2019.01)}$    $B29C\ 48/345^{(2019.01)}$
$B29C\ 48/37^{(2019.01)}$    $B29C\ 48/691^{(2019.01)}$
$B29C\ 48/88^{(2019.01)}$    $B29B\ 7/42^{(2006.01)}$
$B29B\ 7/46^{(2006.01)}$    $B29B\ 9/06^{(2006.01)}$
$G06F\ 30/27^{(2020.01)}$    $B29C\ 48/92^{(2019.01)}$

(52) Cooperative Patent Classification (CPC):
**B29B 7/728; B29C 48/0022; B29C 48/04;
B29C 48/05; B29C 48/2552; B29C 48/345;
B29C 48/37; B29C 48/691; B29C 48/911;**
B29B 7/42; B29B 7/46; B29B 9/06; B29C 48/92;
G06F 30/27

(54) **MACHINE LEARNING METHOD, MACHINE LEARNING DEVICE, AND MACHINE LEARNING PROGRAM**

MASCHINENLERNVERFAHREN, MASCHINENLERNVORRICHTUNG UND MASCHINENLERNPROGRAMM

PROCÉDÉ D'APPRENTISSAGE AUTOMATIQUE, DISPOSITIF D'APPRENTISSAGE AUTOMATIQUE, ET PROGRAMME D'APPRENTISSAGE AUTOMATIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **26.10.2020 JP 2020179177**

(43) Date of publication of application:
**27.04.2022 Bulletin 2022/17**

(73) Proprietor: **KABUSHIKI KAISHA KOBE SEIKO SHO (KOBE STEEL, LTD.)
Hyogo 651-8585 (JP)**

(72) Inventors:
• **IRITANI, Kazuo
Takasago-shi, 676-8670 (JP)**
• **YAMAGUCHI, Kazuo
Takasago-shi, 676-8670 (JP)**
• **GENNAI, Tatsuo
Takasago-shi, 676-8670 (JP)**
• **IWASAKI, Shin
Takasago-shi, 676-8670 (JP)**

• **KURODA, Yoshinori
Takasago-shi, 676-8670 (JP)**

(74) Representative: **TBK
Bavariaring 4-6
80336 München (DE)**

(56) References cited:
**EP-A1- 2 610 041      EP-A1- 3 640 002
EP-A2- 2 065 162      WO-A1-01/24991
JP-A- 2020 163 783    US-A1- 2015 005 903**

• **DREIBLATT, ADAM: "Computer Modeling of Twin-Screw Compounding Using One-Dimensional Process Simulation", 31 December 2012 (2012-12-31), pages 1 - 56, XP055326804, Retrieved from the Internet <URL:http://www.b4uextrude.com/images/SPE_Minitec_Presentation.pdf> [retrieved on 20161207]**

**Description**

**Field of the Invention**

The present invention relates to a technique for machine learning of processing conditions for a resin processing device.

**Background Art**

Conventionally, as a continuous kneading device that continuously kneads a material such as a resin, there is provided a continuous kneading device disclosed in Japanese Patent Application Laid-Open No. 2012-051363 or the like.

The continuous kneading device disclosed in Japanese Patent Application Laid-Open No. 2012-051363 includes a hollow barrel and a kneading rotor housed in the barrel. The kneading rotors are disposed with their axes substantially parallel to each other, and are configured to be rotatable in directions different from each other.

In such a continuous kneading device, a raw material supplied into the barrel is guided between the kneading rotors, and a shearing force is applied to the guided raw material using a kneading screw provided at the kneading rotor, whereby the material is kneaded. For producing a high quality kneaded resin and pellets of the kneaded resin, it is required to appropriately determine kneading conditions.

However, it has been a conventional practice to determine kneading conditions relying on many years of experiences of a skilled engineer. It has been therefore difficult to easily determine an appropriate processing condition for a required pellet state of a resin.

Document EP 3 640 002 A1 discloses an apparatus for inferring extrusion process conditions of a kneading machine for kneading resin or other materials by means of a screw, which may be used typically as an injection molding machine or as an extrusion molding machine

Document EP 2 610 041 A1 discloses a simulation device for deriving a manufacturing condition that enables break-down of a glass fiber bundle that is not broken down, being a cluster of monofilaments, into monofilaments, in manufacturing a resin molded article using a bi- or multi-axial extruder of an engaging type.

Document JP 2020 163 783 A discloses a method for inferring property information of a resin composition produced by a screw extruder from information on a manufacturing condition

**Summary of the Invention**

The present invention has been made to solve such a problem, and it is an object of the present invention to provide a machine learning method and the like which enable an appropriate processing condition for a required pellet state of a resin to be easily determined.

According to one aspect of the present disclosure, there is provided a machine learning method as defined in claim 1.

According to another aspect of the present disclosure, there is provided a machine learning device as defined in claim 11. According to another aspect of the present disclosure, there is provided a machine learning program as defined in claim 12. Further aspects and features of the present disclosure are set out in the dependent claims.

According to this configuration, it is possible to easily determine appropriate processing conditions for a required pellet state of a resin without relying on many years of experiences of a skilled engineer.

**Brief Description of the Drawings**

FIG. 1 is a diagram illustrating an overall configuration of an extruder to be a learning target in an embodiment of the present invention;
FIG. 2 is a diagram illustrating an overall configuration of a kneader to be a learning target;
FIG. 3 is a diagram illustrating an overall configuration of a machine learning system that causes a resin processing device according to the embodiment to perform machine learning;
FIG. 4 is a diagram illustrating an example of processing conditions;
FIG. 5 is a diagram illustrating an example of processing conditions;
FIG. 6 is a diagram illustrating an example of physical quantities;
FIG. 7 is a flowchart illustrating an example of processing in the machine learning system illustrated in FIG. 3; and
FIG. 8 is a diagram illustrating an overall configuration of a machine learning system according to a modification of the present invention.

**Description of Embodiments**

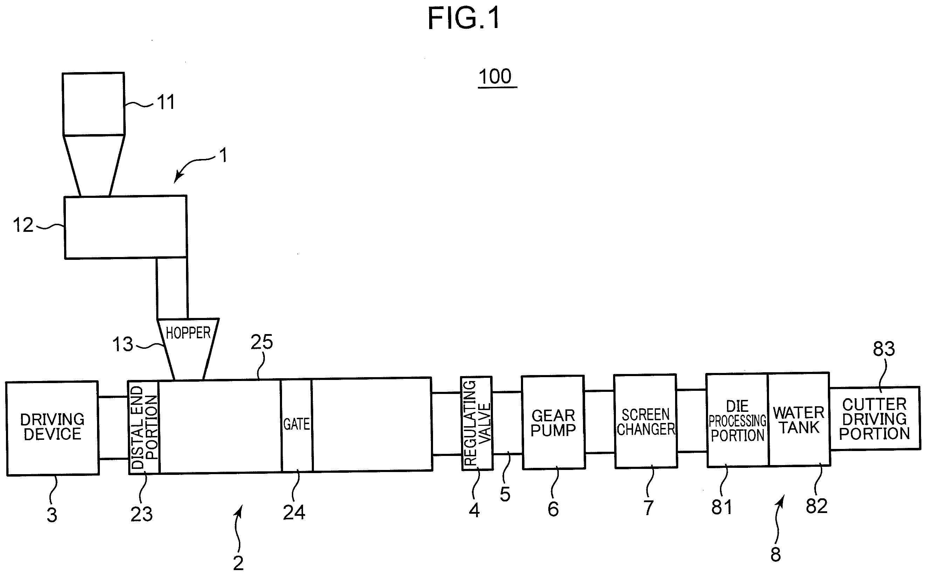

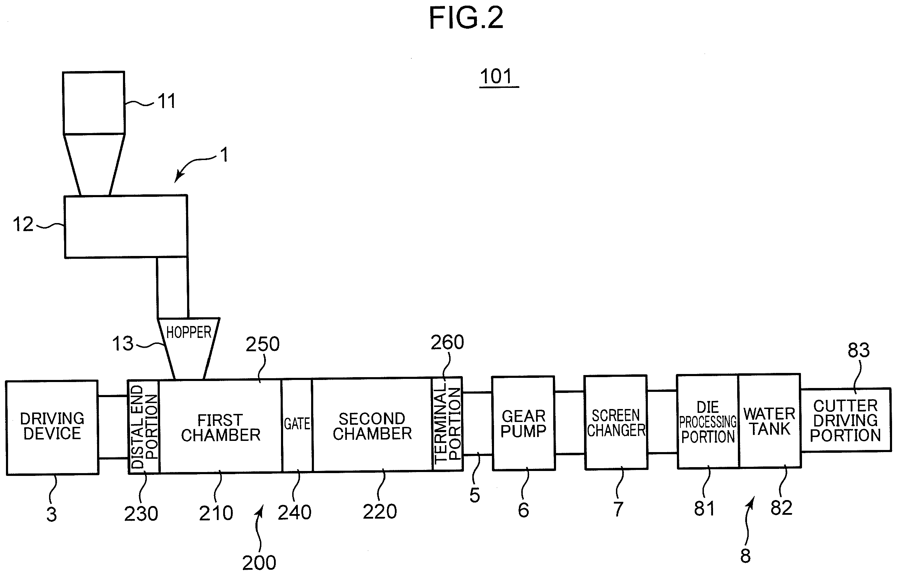

In the present embodiment, two kinds of resin processing devices are assumed to be learning targets. The first resin processing device is an extruder 100 illustrated in FIG. 1. The second resin processing device is a kneader 101 illustrated in FIG. 2. First, the extruder 100 will be described.

FIG. 1 is a diagram illustrating an overall configuration of the extruder 100 to be a learning target in the embodiment of the present invention. The extruder 100 includes a feeder 1, a resin processing unit 2, a driving device 3, a regulating valve 4, a transition piece (T/P) portion 5, a gear pump 6, a screen changer 7, and a pelletizer 8.

The feeder 1 feeds a resin as a raw material to the resin processing unit 2. The feeder 1 includes a storage portion 11, a raw material supply device 12, and a hopper 13. The storage portion 11 stores a resin as a raw material. The raw material supply device 12 regulates an amount of the resin to be supplied to the resin processing unit 2, the resin being stored in the storage portion 11. The hopper 13 inputs the resin supplied from the raw material supply device 12 to the resin processing unit 2.

The resin processing unit 2 is also referred to as an extrusion unit, and outputs the resin to the regulating valve 4 while kneading the resin. The resin processing unit 2 includes two screws (not shown) arranged in parallel along a longitudinal direction of a process container 25, and the process container 25 covering the screws. The process container 25 is configured to be capable of heating and cooling.

The resin processing unit 2 further includes a distal end portion 23 and a gate 24. The distal end portion 23 closes the process container 25. The gate 24 is provided in a middle portion of the resin processing unit 2 so as to be opened and closed in a vertical direction.

The driving device 3 rotationally drives each screw. The regulating valve 4 is provided on a downstream side of the resin processing unit 2, and regulates an amount of the resin to be supplied to the downstream side, the resin being output from the resin processing unit 2. The transition piece portion 5 is provided between the regulating valve 4 and the gear pump 6, and outputs a resin output from the regulating valve 4 to the gear pump 6.

The gear pump 6 is provided on a downstream side of the transition piece portion 5. The screen changer 7 is provided on a downstream side of the gear pump 6. The pelletizer 8 is provided on a downstream side of the screen changer 7. The pelletizer 8 includes a die processing portion 81, a water tank 82, and a cutter driving portion 83. The die processing portion 81 is provided on the downstream side of the screen changer 7. The cutter driving portion 83 cuts a resin output from the pelletizer 8 into pellets.

The foregoing is the description of the extruder 100. Next, the kneader 101 will be described. FIG. 2 is a diagram illustrating an overall configuration of the kneader 101 to be a learning target. Hereinafter, description will be made of only a difference of the kneader 101 from the extruder 100.

The kneader 101 differs from the extruder 100 mainly in the resin processing unit 200. While in the resin processing unit 2, the screw has a single flight, in the resin processing unit 200, the screw has a kneading flight for kneading and an extrusion flight for extruding.

Since in the extruder 100, the resin processing unit 2 can apply, to the resin, a pressure necessary for output from the resin processing unit 2, the gear pump 6 is not an essential component.

The resin processing unit 200 is also referred to as a kneading unit, and includes a first chamber 210, a second chamber 220, a distal end portion 230, a gate 240, a process container 250, and a terminal portion 260. The process container 250 covers two screws (not shown). The two screws rotate in opposite directions. The two screws each have a kneading flight and an extrusion flight as described above.

The resin is kneaded in the first chamber 210 and then extruded to the second chamber 220 through the gate 240, and kneaded in the second chamber 220 and then extruded to the gear pump 6 through the terminal portion 260.

The gate 240 is provided in a middle portion of the process container 250.

The distal end portion 230 is also referred to as a drive end and closes an upstream side of the process container 250. The terminal portion 260 is also referred to as a water end, and closes the downstream side of the process container 250. The transition piece portion 5 is provided between the resin processing unit 200 and the gear pump 6. Since the configuration of the downstream side of the gear pump 6 is the same as that of the extruder 100, the description thereof will be omitted.

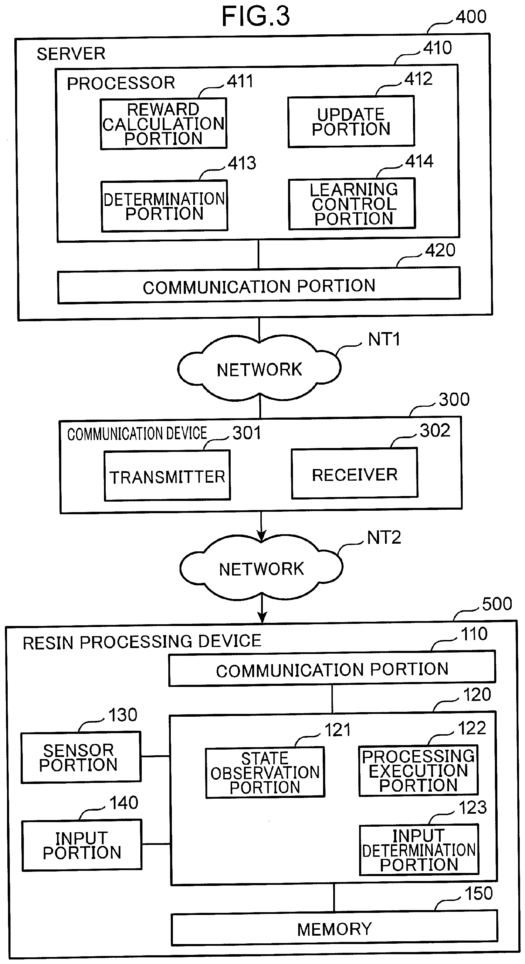

FIG. 3 is a diagram illustrating an overall configuration of a machine learning system that causes the resin processing device according to the embodiment to perform machine learning. The machine learning system includes a resin processing device 500, a communication device 300, and a server 400. The resin processing device 500 is the extruder 100 or the kneader 101. The server 400 and the communication device 300 are communicably connected to each other via a network NT1. The communication device 300 and the resin processing device 500 are communicably connected to each other via a network NT2. The network NT1 is, for example, a wide-area communication network such as the Internet. The network NT2 is, for example, a local area network. The server 400 is, for example, a cloud server including one or more computers. The communication device 300 is, for example, a computer owned by a user who uses the resin processing device 500. The communication device 300 functions as a gateway that connects the resin processing device 500 to the network NT1. The communication device 300 is realized by installing dedicated application software in a computer owned by the user. Alternatively, the communication device 300 may be a dedicated device provided to the user by a manufacturer of the resin processing device 500.

Hereinafter, a configuration of each device will be specifically described. The server 400 includes a processor 410 and a communication portion 420. The processor 410 is a control device including a CPU and the like. The processor 410 includes a reward calculation portion 411, an update portion 412, a determination portion 413, and a learning control portion 414. Each block included in the processor 410 may be realized by execution, by the processor 410, of a machine learning program for causing a computer to function as the server 400 in the machine learning system, or may be realized by a dedicated electric circuit.

The reward calculation portion 411 calculates a reward for a determination result of at least one processing condition based on a state variable observed by the state observation portion 121.

The update portion 412 updates a function for determining a processing condition from a state variable observed by the state observation portion 121 based on a reward calculated by the reward calculation portion 411. As the function, an action value function to be described later is adopted.

The determination portion 413 determines a processing condition under which a most reward can be obtained by repeating updating of a function while changing at least one processing condition.

The learning control portion 414 performs overall control of machine learning. The machine learning system according to the present embodiment learns processing conditions by reinforcement learning. The reinforcement learning is a machine learning method in which an agent (action subject) selects a certain action based on a situation of an environment, changes the environment based on the selected action, and gives a reward associated with the environment change to the agent, thereby causing the agent to learn selection of a better action. As the reinforcement learning, Q learning and TD learning can be adopted. In the following description, Q learning will be described as an example. In the present embodiment, the reward calculation portion 411, the update portion 412, the determination portion 413, the learning control portion 414, and the state observation portion 121 to be described later correspond to an agent. In the present embodiment, the communication portion 420 is an example of a state acquisition portion that acquires a state variable.

The communication portion 420 includes a communication circuit that connects the server 400 to the network NT1. The communication portion 420 receives a state variable observed by the state observation portion 121 via the communication device 300. The communication portion 420 transmits a processing condition determined by the determination portion 413 to the resin processing device 500 via the communication device 300.

The communication device 300 includes a transmitter 301 and a receiver 302. The transmitter 301 transmits a state variable transmitted from the resin processing device 500 to the server 400, and transmits a processing condition transmitted from the server 400 to the resin processing device 500. The receiver 302 receives a state variable transmitted from the resin processing device 500 and receives a processing condition transmitted from the server 400.

The resin processing device 500 includes a communication portion 110, a processor 120, a sensor portion 130, an input portion 140, and a memory 150.

The communication portion 110 is a communication circuit for connecting the resin processing device 500 to the network NT2. The communication portion 110 transmits a state variable observed by the state observation portion 121 to the server 400. The communication portion 110 receives a processing condition determined by the determination portion 413 of the server 400. The communication portion 110 receives a processing execution command determined by the learning control portion 414, the processing execution command being described later.

The processor 120 is a computer including a CPU and the like. The processor 120 includes the state observation portion 121, a processing execution portion 122, and an input determination portion 123. The communication portion 110 transmits a state variable acquired by the state observation portion 121 to the server 400. Each block included in the processor 120 is realized by, for example, execution of a machine learning program causing a CPU to function as the resin processing device 500 of the machine learning system.

The state observation portion 121 acquires a physical quantity detected by the sensor portion 130 after execution of the processing. The state observation portion 121 observes a state variable including at least one physical quantity related to a pellet state of a resin and at least one processing condition after execution of the processing. Specifically, the state observation portion 121 acquires a processing condition based on a measurement value of the sensor portion 130 and a set value of the processing execution portion 122. In addition, the state observation portion 121 acquires a physical quantity based on a measurement value of the sensor portion 130 or the like.

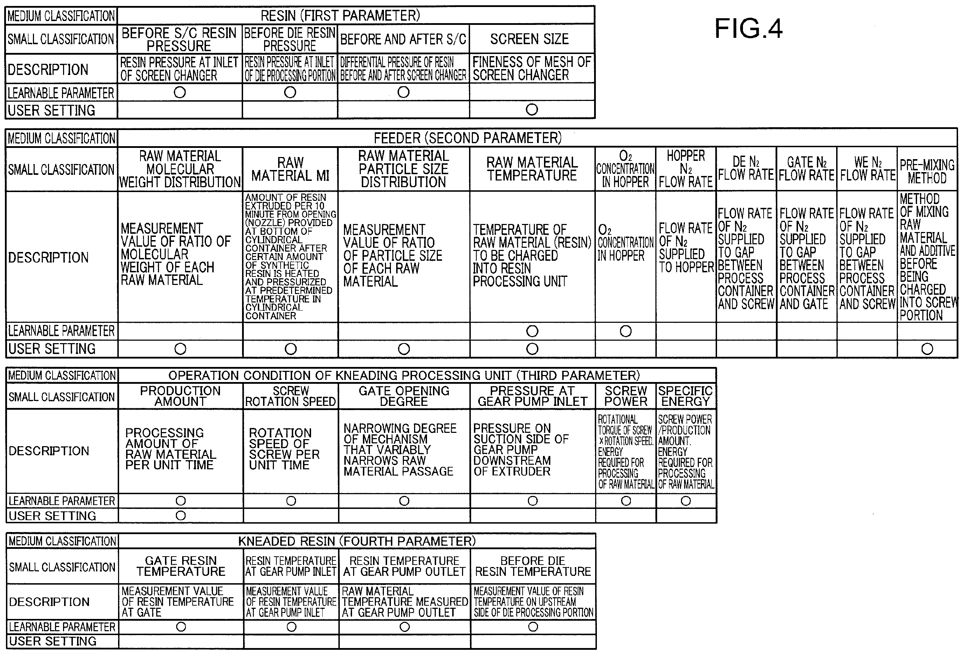

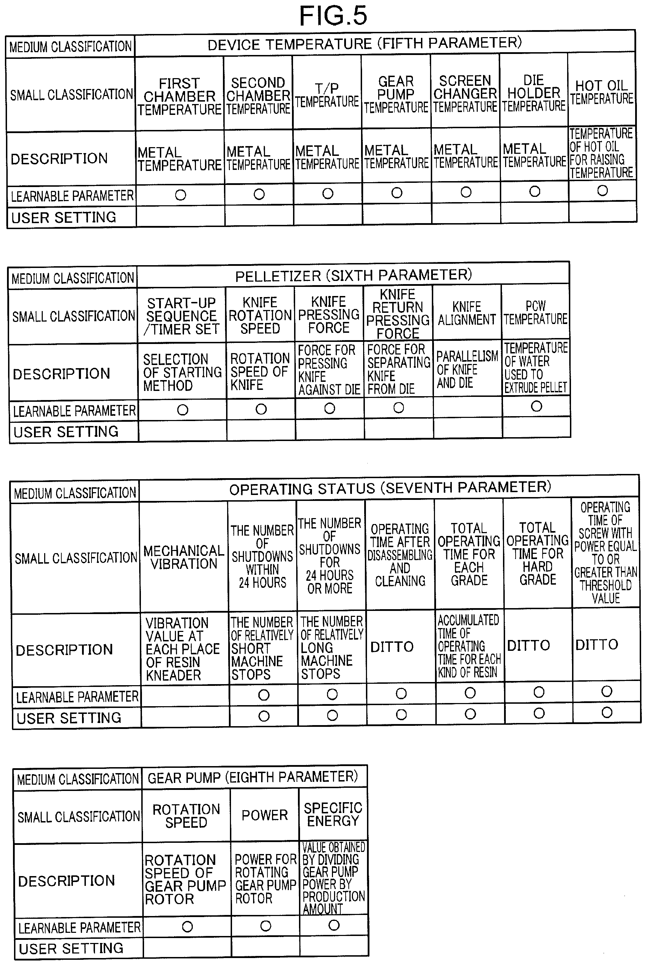

FIG. 4 and FIG. 5 are diagrams illustrating examples of processing conditions. The processing conditions are roughly classified into a medium classification. The medium classification includes at least one of a first parameter related to a resin, a second parameter related to the feeder 1, a third parameter related to an operation condition of the kneading processing unit, a fourth parameter related to a kneaded resin, a fifth parameter related to a temperature of the resin processing device, a sixth parameter related to the pelletizer 8, a seventh parameter related to an operating status of the resin processing device, and an eighth parameter related to the gear pump 6. In the tables, a parameter with o indicated in the user setting is a parameter whose value can be designated by operating the input portion 140 by a user. Note that these parameters may or may not be learning targets in machine learning. In a case where these parameters are to be learning targets, user's input of a value may be omitted. In the tables, a parameter with o indicated in the learnable parameter is a parameter that is in particular preferably learned. However, this is an example, and a parameter having no ∘ attached to the learning parameter may be set as a learning target.

The first parameter includes at least one of a before S/C (screen changer 7) resin pressure, a before die resin pressure, a before and after S/C resin pressure, and a screen size. The before S/C resin pressure represents a pressure of a resin at an inlet of the screen changer 7. The before die resin pressure represents a pressure of a resin at an inlet of the die processing portion 81. The before and after S/C resin pressure represents a pressure of a resin between the inlet and an outlet of the screen changer 7. The screen size indicates a size (fineness) of a mesh of the screen changer 7. Values of various pressures constituting the first parameter can be measured by a pressure sensor (not illustrated). A value of the screen size is input by the user.

The second parameter includes at least one of a raw material molecular weight distribution, a raw material MI, a raw material particle size distribution, a raw material temperature, an $O_2$ concentration in the hopper, a hopper $N_2$ concentration, a $DEN_2$ flow rate, a gate $N_2$ flow rate, a $WEN_2$ flow rate, and a pre-mixing method. The raw material molecular weight distribution indicates a distribution of molecular weights of one or more raw materials constituting the resin. The raw material MI is an amount of a synthetic resin extruded per 10 minutes when a certain amount of the synthetic resin is heated and pressurized at a predetermined temperature in a cylindrical container and the synthetic resin is extruded from an opening (nozzle) provided at a bottom of the cylindrical container. The raw material particle size distribution represents a measurement value of the ratio of each raw material constituting the resin. The raw material temperature represents a temperature of a resin (raw material) to be charged into the resin processing unit 2 or 200.

The $O_2$ concentration in the hopper is an oxygen concentration in the hopper 13 connected to a raw material charging port of the resin processing unit 2 or 200. The hopper $N_2$ flow rate is a nitrogen flow rate supplied to the hopper 13. The $DEN_2$ flow rate represents a flow rate of nitrogen in the distal end portion 23 or 230, the nitrogen being supplied to a gap between the screw and the process container 250. The gate $N_2$ flow rate represents a flow rate of nitrogen supplied to a gap between the gate 24 or 240 and the process container 250. The $WEN_2$ flow rate represents a flow rate of nitrogen in the terminal portion 260 of the process container 250, the nitrogen being supplied to a gap between the process container 250 and the screw. The pre-mixing method is a method of mixing a resin raw material and an additive before being charged into the resin processing unit 2 or 200. The second parameter, excluding the pre-mixing method, is measured by various sensors such as a flowmeter, a thermometer, and a densitometer. The pre-mixing method is input by the user.

The third parameter includes at least one of a production amount, a screw rotation speed, a gate opening degree, a pressure at a gear pump inlet, screw power, and specific energy. The production amount is a processing amount of a raw material forming the resin per unit time. The screw rotation speed is a rotation speed of the screw per unit time. The gate opening degree is an opening degree of the gate 24 or 240. The pressure at a gear pump inlet is a pressure at an inlet of the gear pump 6. The screw power is defined by the rotational torque of the screw × the rotation speed, and is energy required for the processing of the raw material. The specific energy is defined by screw power/production amount, and is energy required for processing. These values constituting the third parameter are set by the processing execution portion 122. Note that a value set by a user may be used for the production amount.

The fourth parameter includes at least one of a gate resin temperature, a resin temperature at the gear pump inlet, a resin temperature at a gear pump outlet, and a before die resin temperature. The gate resin temperature is a temperature of the resin in the gate 24 or 240. The gate resin temperature can be controlled by an opening degree of the gate 24 or 240. The resin temperature at the gear pump inlet is a resin temperature at the inlet of the gear pump 6. The resin temperature at the gear pump inlet can be controlled by regulating a pressure of the resin at the gear pump inlet. The resin temperature at the gear pump outlet is a resin temperature at the outlet of the gear pump 6. The before die resin temperature is a resin temperature on an upstream side of the die processing portion 81. Various temperatures constituting the fourth parameter are measured by a thermometer.

Reference will be made to FIG. 5. The fifth parameter includes at least one of a first chamber temperature, a second chamber temperature, a T/P temperature, a gear pump temperature, a screen changer temperature, a die holder temperature, and a hot oil temperature.

The first chamber temperature is a metal temperature of the first chamber 210. The second chamber temperature is a metal temperature of the second chamber 220. In the extruder 100, a temperature of metal on the upstream side of the gate 24 in the process container 25 is adopted as the first chamber temperature, and a temperature of metal on the downstream side of the gate 24 in the process container 25 is adopted as the second chamber temperature.

The T/P temperature is a temperature of metal in the transition piece portion 5. The gear pump temperature is a metal temperature of the gear pump 6. The screen changer temperature is a metal temperature of the screen changer 7. The die holder temperature is a metal temperature of a holder included in the die processing portion 81. The hot oil temperature is a temperature of a hot oil for raising the temperature of the die processing portion 81. Various temperatures of the fifth parameter can be controlled by regulating temperatures of heaters for heating the first chamber 210, the second chamber 220, the transition piece portion 5, the gear pump 6, the screen changer 7, the die holder, and the hot oil, respectively. Various temperatures of the fifth parameter are measured by a thermometer.

The sixth parameter includes at least one of start-up, a knife rotation speed, a knife pressing force, a knife return pressing force, knife alignment, and a PCW temperature. The start-up represents a method of starting the pelletizer 8. The knife rotation speed is a rotation speed of a knife included in the cutter driving portion 83. The knife pressing force is a force for pressing the knife against the die. The knife return pressing force is a force for separating the knife from the die. The knife alignment is parallelism of the knife and the die. The PCW temperature is a temperature of water used to extrude the pellet. Various values of the sixth parameter are set by the processing execution portion 122.

The seventh parameter includes at least one of a mechanical vibration frequency, a number of shutdowns within 24 hours, a number of shutdowns for 24 hours or more, an operating time after disassembling and cleaning, a total operating time for each grade, a total operating time for a hard grade, and an operating time of the screw with power equal to or greater than a threshold value.

The mechanical vibration frequency is a mechanical vibration frequency of the resin processing device 500. The number of shutdowns within 24 hours is the number of shutdowns of the resin processing device 500 within 24 hours. The number of shutdowns for 24 hours or more is the number of shutdowns of the resin processing device 500 for 24 hours or more. The operating time after disassembling and cleaning is an operating time after the disassembling and cleaning of the resin processing device 500. The total operating time for each grade is an accumulated time of the operating time of the resin processing device 500 for each kind of resin. The total operating time for a hard grade is an accumulated time of the operating time of the resin processing device 500 for a specific hard grade resin as a key. The operating time of the screw with power equal to or greater than a threshold value is an accumulated operating time of the resin processing device 500 in which the screw operates with the power equal to or greater than the threshold value.

The eighth parameter includes at least one of a rotation speed, power, and specific energy. The rotation speed is a rotation speed of a gear pump rotor included in the gear pump 6. The power is power for rotating the gear pump rotor. The specific energy is a value obtained by dividing the gear pump power by a production amount. Various values of the eighth parameter are set by the processing execution portion 122.

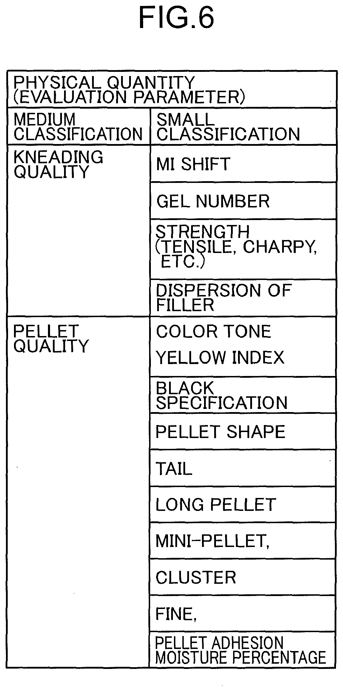

FIG. 6 is a diagram illustrating an example of physical quantities. The physical quantity includes at least one of kneading quality and pellet quality. The kneading quality represents a physical quantity related to a kneading quality of a pelletized resin. The pellet quality represents a physical quantity related to a pellet quality of a pelletized resin. The kneading quality includes MI (melt index) shift, gel number, strength, and filler dispersion.

The MI shift is defined by pellet MI/powder MI. The MI shift is measured by an MI measuring machine. The gel number is the number of gels per 1 $m^2$ or per 1 $ft^2$ at a specified thickness of the pellet. The gel number is measured by a film molding machine and a gel counter. The strength is a tensile strength measured by a Charpy impact tester or the like. The dispersion of the filler is the number of filler agglomerates per 1 $m^2$ or per 1 $ft^2$ at a specified thickness. The dispersion of the filler is measured by a film molding machine and a gel counter.

The pellet quality includes at least one of a color tone, a black specification, a pellet shape, a tail, a long pellet, a mini-pellet, a cluster, a fine, and a pellet adhesion moisture percentage. The color tone represents a yellow component amount of a pellet measured by a color difference meter. The black specification represents the number of pellets including black spots per unit amount. The black specification is visually measured. The pellet shape is measured as the major axis × minor axis of the pellet × a length in MD (machine direction: resin flow direction) direction.

The tail represents the number of pellets including tails per unit amount. The tail is visually measured. The long pellet represents an amount of pellets over a vibration sieve and discharged per production amount. The long pellet is carried out by measuring a weight of a long pellet.

The mini-pellet represents an amount of pellets under the vibrating sieve and discharged per production amount. The mini-pellet is obtained by measuring a weight of a mini-pellet. The cluster represents an amount of pellets over the vibration sieve and discharged per production amount. The cluster is obtained by measuring a weight of a cluster. The fine represents an amount of pellets captured by a PCW filter per unit time. The fine is obtained by measuring a weight of a pellet. The pellet adhesion moisture percentage represents a pellet adhesion moisture at a dryer outlet. The fine is obtained by measuring a weight of a fine.

Note that all the physical quantities illustrated in FIG. 6 are measured off-line. The off-line measurement is, for example, a measuring method with a measuring instrument existing independently of the resin processing device 500. This measurement result is input to the resin processing device 500 by a user operating the input portion 140, for example.

Next, a degree of influence of a processing condition on a physical quantity will be described. First, a degree of influence of the second parameter will be described. The raw material molecular weight distribution has a large influence (influence by a first influence degree) on the gel number and the strength shown in FIG. 6, and has an influence on the pellet shape and the tail by a second influence degree smaller than the first influence degree. The raw material MI influences the MI shift, the pellet shape, the tail, the long pellet, the mini-pellet, the cluster, and the fine shown in FIG. 6 by the first influence degree. A raw material particle size distribution influences the gel number shown in FIG. 6 by the first influence degree. The raw material temperature influences the MI shift by the second influence degree. Each of the $O_2$ concentration in the hopper and the hopper $N_2$ concentration influences the MI shift, the color tone, and the black specification illustrated in FIG. 6 by the first influence degree. Each of the hopper $N_2$ flow rate, the $DEN_2$ flow rate, the gate $N_2$ flow rate, and the $WEN_2$ flow rate influences the color tone and the black specification illustrated in FIG. 6 by the first influence degree. The pre-mixing method influences the gel number and the dispersion of the filler shown in FIG. 6 by the first influence degree.

Next, an influence degree of the third parameter will be described. The production amount influences the gel number, the strength, the dispersion of the filler, and the pellet adhesion moisture percentage shown in FIG. 6 by the first influence degree, and influences the MI shift, the pellet shape, and the tail by the second influence degree. Each of the screw rotation speed, the gate opening degree, the pressure at a gear pump inlet, and the specific energy influences the MI shift, the gel number, the strength, the dispersion of the filler, the color tone, and the black specification illustrated in FIG. 6 by the first influence degree.

Next, an influence degree of the fourth parameter will be described. Each of the gate resin temperature and the resin temperature at the inlet of the gear pump influences the MI shift, the gel number, the strength, the dispersion of the filler, the color tone, and the black specification illustrated in FIG. 6 by the first influence degree, and influences the pellet shape, the tail, the long pellet, the mini-pellet, the cluster, the fine, and the pellet adhesion moisture percentage by the second influence degree. The resin temperature at the gear pump outlet influences the MI shift, the color tone, and the black specification illustrated in FIG. 6 by the first degree of influence, and influences the gel number, the strength, the dispersion of fillers, the pellet shape, the tail, the long pellet, the mini-pellet, the cluster, the fine, and the pellet adhesion moisture percentage by the second degree of influence. The before die resin temperature influences the MI shift, the color tone, the black specification, the pellet shape, the tail, the long pellet, the mini-pellet, the cluster, the fine, and the pellet adhesion moisture percentage shown in FIG. 6 by the first influence degree, and influences the gel number, the strength, and the dispersion of the fillers by the second influence degree.

Next, an influence degree of the sixth parameter will be described. All elements of the sixth parameter influence the MI shift illustrated in FIG. 6 by the second influence degree. In addition, the hot oil temperature influences the pellet shape, the tail, the long pellet, the mini-pellet, the cluster, and the fine illustrated in FIG. 6 by the first influence degree.

Next, an influence degree of the seventh parameter will be described. The start-up influences the pellet shape, the tail, the long pellet, the mini-pellet, the cluster, and the fine by the first influence degree. The knife rotation speed, the knife pressing force, the knife return pressing force, and the knife alignment influence the pellet shape, the tail, the cluster, and the fine by the first influence degree. The PCW temperature influences the pellet shape, the tail, the long pellet, the mini-pellet, the cluster, the fine, and the pellet adhesion moisture percentage by the first influence degree.

Next, an influence degree of the eighth parameter will be described. Each of the number of shutdowns within 24 hours, the number of shutdowns for 24 hours or more, the operating time after disassembling and cleaning, and the total operating time for each grade influences the black specification by the first influence degree.

Note that the relationship in the influence degree between the various parameters and the physical quantities described above is an example, and a parameter for a processing condition not described above may influence the physical quantities by a third influence degree smaller than the second influence degree.

Reference will be returned to FIG. 3. The processing execution portion 122 controls execution of processing by the resin processing device 500. The input determination portion 123 automatically or manually determines whether it is a mass production process or not. In a case of automatically determining whether the process is a mass production process or not, when the number of times of input of a condition number to the input portion 140 exceeds a reference number, the input determination portion 123 determines that the resin processing device 500 is in the mass production process. The condition number is an identification number for specifying a certain processing condition. The processing condition specified by the condition number includes at least a processing condition having o indicated in the user setting among the processing conditions illustrated in FIG. 4 and FIG. 5.

In the case of manually determining whether it is a mass production process or not, when data indicative of a mass production process is input to the input portion 140, the input determination portion 123 determines that the resin processing device 500 is in the mass production process. In the case of the mass production process, the resin processing device 500 does not perform machine learning.

The memory 150 is, for example, a nonvolatile storage device, and stores a finally determined optimum processing condition and the like.

The sensor portion 130 corresponds to various sensors used for measuring the processing conditions illustrated in FIG. 4 and FIG. 5 and the physical quantities illustrated in FIG. 6. Specifically, the sensor portion 130 is a thermometer, a pressure gauge, or the like. The input portion 140 corresponds to input devices such as a keyboard and a mouse. Although in FIG. 3, the sensor portion 130 is provided inside the resin processing device 500, this is an example, and the sensor portion may be provided outside the resin processing device 500, and an installation location of the sensor portion 130 is not particularly limited.

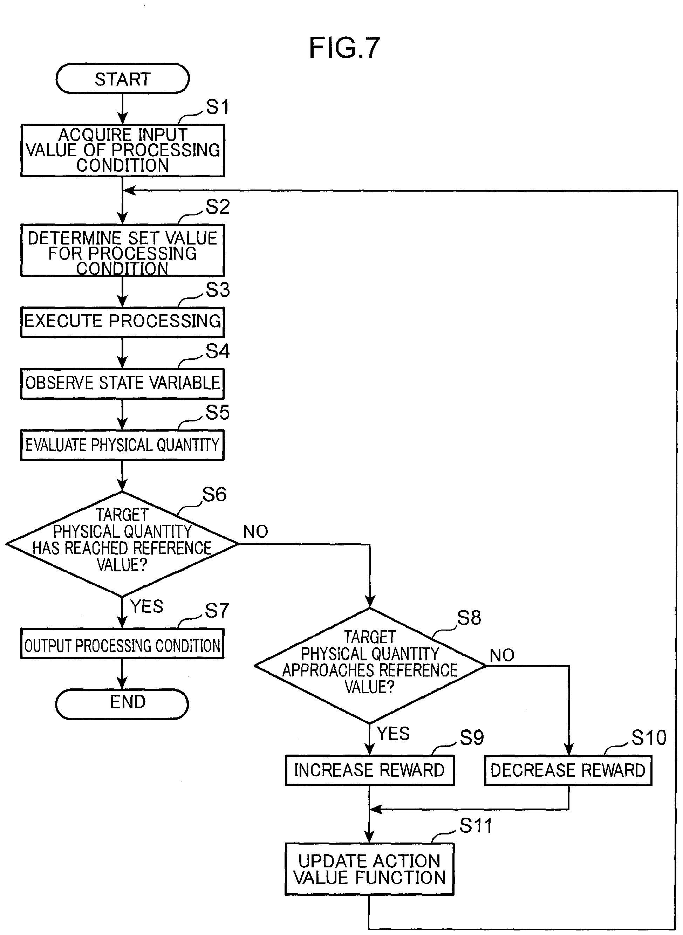

FIG. 7 is a flowchart illustrating an example of processing in the machine learning system illustrated in FIG. 2.

In step S1, the learning control portion 414 acquires an input value of a processing condition input by a user using the input portion 140. The input value acquired here is an input value for a processing condition having o indicated in the user setting among the processing conditions listed in FIG. 4 and FIG. 5.

In step S2, the learning control portion 414 determines at least one processing condition and a set value for each processing condition. Here, the processing condition to be set is at least one processing condition for which a set value can be set among the processing conditions listed in FIG. 4 and FIG. 5. The at least one processing condition for which a set value can be set includes, for example, a processing condition having o indicated in the learnable parameter in FIG. 4 and FIG. 5. Here, the set value of the determined processing condition corresponds to an action in reinforcement learning.

Specifically, the learning control portion 414 at random selects a set value for each processing condition to be set. Here, the set value is selected at random from a predetermined range for each processing condition. As a method of selecting a set value for a processing condition, for example, the $\varepsilon$-greedy method can be adopted.

In step S3, the learning control portion 414 transmits a processing execution command to the resin processing device 500 to cause the resin processing device 500 to start processing. When the processing execution command is received by the communication portion 110, the processing execution portion 122 sets a processing condition according to the processing execution command and starts processing. The processing execution command includes the input value for the processing condition set in step S 1, the set value for the processing condition determined in step S2, and the like.

When the processing ends, the state observation portion 121 observes the state variable (step S4). Specifically, the state observation portion 121 acquires the physical quantities illustrated in FIG. 6 and a processing condition to be observed among the processing conditions illustrated in FIG. 4 and FIG. 5 as state variables. The physical quantity may be input to the resin processing device 500 by, for example, a user operating the input portion 140, or may be input to the resin processing device 500 by communication between a measuring instrument that measures the physical quantity and the resin processing device 500. The state observation portion 121 transmits the acquired state variable to the server 400 via the communication portion 110.

In step S5, the determination portion 413 evaluates the physical quantity. Here, the determination portion 413 evaluates a physical quantity by determining whether or not a physical quantity to be evaluated (hereinafter, the physical quantity is referred to as a target physical quantity) among the physical quantities acquired in step S4 has reached a predetermined reference value. The target physical quantity is one or a plurality of physical quantities among the physical quantities listed in FIG. 6. In a case where there are a plurality of target physical quantities, there will exist a plurality of reference values corresponding to the respective target physical quantities. As the reference value, for example, a predetermined value indicating that a target physical quantity has reached a certain reference can be adopted.

The reference value may be, for example, a value including an upper limit value and a lower limit value. In this case, when a target physical quantity falls within a range between the upper limit value and the lower limit value, determination is made that the target physical quantity has reached the reference value. The reference value may be one value. In this case, when the target physical quantity exceeds the reference value or falls below the reference value, determination is made that a certain standard is satisfied.

When determining that the target physical quantity has reached the reference value (YES in step S6), the determination portion 413 outputs the processing condition set in step S2 as a final processing condition (step S7). On the other hand, when the determination portion 413 determines that the physical quantity has not reached the reference value (NO in step S6), the processing proceeds to step S8. Note that in a case where there are a plurality of target physical quantities, the determination portion 413 need only determine YES in step S6 when all the target physical quantities have reached the reference value.

In step S8, the reward calculation portion 411 determines whether or not the target physical quantity approaches the reference value. In a case where the target physical quantity approaches the reference value (YES in step S8), the reward calculation portion 411 increases a reward for the agent (step S9). On the other hand, in a case where the target physical quantity does not approach the reference value (NO in step S8), the reward calculation portion 411 decreases the reward for the agent (step S10). In this case, the reward calculation portion 411 need only increase or decrease the reward according to a predetermined increase/decrease value of the reward. Note that in a case where there are a plurality of target physical quantities, the reward calculation portion 411 need only perform the determination of step S8 for each of the plurality of target physical quantities. In this case, the reward calculation portion 411 need only increase or decrease the reward for each of the plurality of target physical quantities based on the determination result of step S8. In addition, a different value may be adopted as the increase/decrease value of the reward according to a target physical quantity.

In addition, in a case where the target physical quantity does not approach the reference value (NO in step S8), the processing of decreasing the reward (step S10) may be omitted. In this case, the reward will be given only when the target physical quantity approaches the reference value.

In step S11, the update portion 412 updates the action value function using the reward given to the agent. The Q learning adopted in the present embodiment is a method of learning a Q value (Q (s, a)) which is a value for selecting an action a under a certain environmental state s. Note that an environment state st corresponds to a state variable of the above flow. Then, in the Q learning, an action a with the highest Q (s, a) is selected in a certain environmental state s. In the Q learning, various actions a are taken under a certain environmental state s by trial and error, and a correct Q (s, a) is learned using a reward at that time. An update formula of the action value function Q (st, at) is expressed by the following formula (1).

[Mathematical Formula 1]

$$Q(s_t , a_t) \leftarrow Q(s_t , a_t) + \alpha \left( r_{t+1} + \gamma \max_a Q(s_{t+1} , a) - Q(s_t , a_t) \right) \quad \cdots (1)$$

Here, st and at represent an environmental state and an action at time t, respectively. The environmental state changes to $s_{t+1}$ as a result of the action at, and a reward $r_{t+1}$ is calculated as a result of the environmental state change. In addition, the term with max is obtained by multiplying, by $\gamma$, a Q value (Q ($s_{t+1}$, a)) in a case where a most valuable action a known at that time is selected under the environmental state st+ ₁. Here, $\gamma$ represents a discount rate, and has a value of $0 < \gamma \leq 1$ (normally 0.9 to 0.99). $\alpha$ represents a learning coefficient and has a value of $0 < \alpha \leq 1$ (normally about 0.1).

In this update formula, when $\gamma$ . maxQ ($s_{t+1}$, a) based on the Q value at the time of taking the best action in the next environmental state $s_{t+1}$ brought by the action a is larger than Q (st, at) which is the Q value of the action a in the state s, Q (st, at) is increased. On the other hand, in this update formula, if $\gamma \cdot$ maxQ ($s_{t+1}$, a) is smaller than Q (st, at), Q (st, at) is decreased. In other words, a value of a certain action a in a certain state st is caused to approach a value of a best action in the next state $s_{t+1}$ brought by the certain action a. As a result, an optimal processing condition is determined.

When the processing of step S11 ends, the processing returns to step S2, the set value for the processing condition is changed, and the action value function is similarly updated. Although the update portion 412 updates the action value function, the present invention is not limited thereto, and the action value table may be updated.

As Q (s, a), values for pairs (s, a) of all states and actions may be stored in a table format. Alternatively, Q (s, a) may be expressed by an approximation function that approximates values for the pairs (s, a) of all the states and actions. This approximation function may be configured by a neural network having a multilayer structure. In this case, the neural network need only perform online learning in which data obtained by actually moving the resin processing device 500 is learnt in real time and the learnt data is reflected in the next action.

Conventionally, in a resin processing device, processing conditions have been developed by changing processing conditions so as to obtain resin pellets satisfying requirements. In order to obtain good processing conditions, it is required to find a relationship between an evaluation of a pellet state of a resin and a processing condition. However, as illustrated in FIG. 4 and FIG. 5, since the number of kinds of processing conditions is enormous, an extremely large number of physical models are required to define such a relationship, so that knowledge has been obtained that it is difficult to describe such a relationship with a physical model. Furthermore, in order to construct such a physical model, it is also required to artificially find which parameter influences an evaluation of which physical quantity, which requirement makes this construction difficult.

According to the present embodiment, at least one of the first to eighth parameters and at least one physical quantity of the kneading quality and the pellet quality are observed as state variables. Then, a reward for a determination result of a processing condition is calculated based on the observed state variable, an action value function for determining a processing condition from the state variable is updated based on the calculated reward, and a processing condition for obtaining a most reward is learned by repeating this update. As described above, in the present embodiment, a processing condition is determined by machine learning without using the above-described physical model. As a result, the present embodiment enables an appropriate processing condition to be easily determined without relying on many years of experiences of a skilled engineer.

Note that the present invention allows the following modifications to be employed.

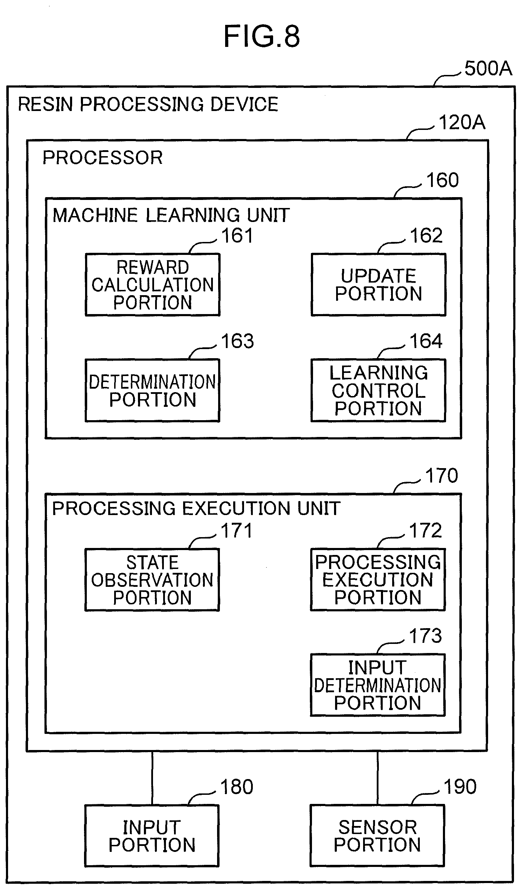

(1) FIG. 8 is a diagram illustrating an overall configuration of a machine learning system according to a modification of the present invention. The machine learning system according to this modification is configured by a resin processing device 500A alone. The resin processing device 500A includes a processor 120A, an input portion 180, and a sensor portion 190. The processor 120A includes a machine learning unit 160 and a processing execution unit 170. The machine learning unit 160 includes a reward calculation portion 161, an update portion 162, a determination portion 163, and a learning control portion 164. The reward calculation portion 161 to the learning control portion 164 are the same as the reward calculation portion 411 to the learning control portion 414 illustrated in FIG. 3, respectively. The processing execution unit 170 includes a state observation portion 171, a processing execution portion 172, and an input determination portion 173. The state observation portion 171 to the input determination portion 173 are the same as the state observation portion 121, the processing execution portion 122, and the input determination portion 123 illustrated in FIG. 3, respectively. The input portion 180 and the sensor portion 190 are the same as the input portion 140 and the sensor portion 130 illustrated in FIG. 3, respectively. In the present modification, the state observation portion 121 is an example of a state acquisition portion that acquires state information. Note that the sensor portion 190 may be provided inside the resin processing device 500A or may be provided outside the resin processing device 500A, and an installation location of the sensor portion 190 is not particularly limited.

As described above, the machine learning system according to this modification enables an optimal processing condition to be learned by the resin processing device 500A alone.

(2) Although in the above flow, the state variable is observed after the end of the processing, this is an example, and a plurality of state variables may be observed during one processing. For example, in a case where the state variable includes only a parameter that can be instantaneously measured, a plurality of state variables can be observed during one processing. As a result, the learning time can be shortened.

(3) A communication method according to the present invention is executed by various kinds of processing performed when the resin processing device 500 illustrated in FIG. 3 communicates with the server 400. In addition, a learning program according to the present invention is realized by a program that causes a computer to function as the server 400 illustrated in FIG. 3.

(Summary of Embodiments)

A machine learning method according to one aspect of the present disclosure is a machine learning method in which a machine learning device determines a processing condition of a resin processing device, in which the resin processing device includes a resin processing unit that has a rotating screw and a process container covering the screw, and kneads and outputs a fed resin; a feeder configured to feed the resin to the resin processing unit; and a pelletizer that downstream of the resin processing unit, pelletizes the resin output from the resin processing unit, the machine learning method including acquiring a state variable including at least one physical quantity related to a pellet state of the resin and at least one processing condition; calculating a reward for a determination result of the at least one processing condition based on the state variable; updating a function for determining the at least one processing condition from the state variable based on the reward; and determining a processing condition under which the reward is most obtained by repeating updating of the function; and in which the at least one processing condition is at least one of: a first parameter related to the resin; a second parameter related to the feeder; a third parameter related to an operation condition of the resin processing unit; a fourth parameter related to a kneaded resin; a fifth parameter related to a temperature of the resin processing device; a sixth parameter related to the pelletizer; and a seventh parameter related to an operating status of the resin processing device, and the at least one physical quantity is at least one of kneading quality and pellet quality.

According to the present aspect, at least one processing condition is acquired as a state variable among the first parameter related to the resin; the second parameter related to the feeder; the third parameter related to an operation condition of the resin processing unit; the fourth parameter related a kneaded resin; the fifth parameter related to a temperature of the resin processing device; the sixth parameter related to the pelletizer; and the seventh parameter related to an operating status of the resin processing device. Further, at least one physical quantity of the kneading quality and the pellet quality of the pelletized resin is acquired as a state variable.

Then, a reward for the determination result of the processing condition is calculated based on the acquired state variable, a function for determining the processing condition from the state variable is updated based on the calculated reward, and a processing condition for obtaining a most reward is learned by repeating this update. Therefore, in this configuration, a processing condition can be easily determined without relying on many years of experiences of a skilled engineer.

Preferably in the machine learning method, the resin processing device further includes a gear pump that is provided between the resin processing unit and the pelletizer and pulls out a kneaded resin from the resin processing unit, and the at least one processing condition further includes an eighth parameter related to the gear pump.

According to the present aspect, since the eighth parameter related to the gear pump is acquired as the state variable, a more appropriate processing condition can be determined.

In the machine learning method, the first parameter is preferably at least one of a before screen changer resin pressure that indicates a pressure of a resin at an inlet of a screen changer that is provided downstream of the resin processing unit and filters impurities in the resin; a before die resin pressure that indicates a pressure of the resin at an inlet of a die processing portion included in the pelletizer; a differential pressure of the resin between the inlet and an outlet of the screen changer; and a screen size that indicates fineness of a mesh of the screen changer.

According to the present aspect, since at least one of the before screen changer resin pressure, the before die resin pressure, the differential pressure of the resin between the inlet and the outlet of the screen changer, and the screen size indicating the fineness of the mesh of the screen changer is adopted as the first parameter, a more appropriate processing condition can be determined.

In the machine learning method, the second parameter is preferably at least one of a raw material molecular weight distribution indicating a distribution of molecular weights of one or more raw materials constituting the resin; a raw material MI; a raw material particle size distribution; a raw material temperature; an oxygen concentration in a hopper included in the feeder; a nitrogen flow rate of the hopper; a flow rate of nitrogen, at a distal end portion of the process container, supplied to a gap between the screw and the process container; a flow rate of nitrogen supplied to a gap between a gate provided in a middle portion of the process container and the process container; a flow rate of nitrogen, at a terminal portion of the process container, supplied to a gap between the process container and the screw; and a pre-mixing method of mixing the at least one raw material and an additive before being charged into the resin processing unit.

According to the present aspect, since at least one of the raw material molecular weight distribution; the raw material MI; the raw material particle size distribution; the raw material temperature; the oxygen concentration in the hopper; the flow rate of nitrogen in the hopper; the flow rate of nitrogen, at the distal end portion of the process container, supplied to a gap between the screw and the process container; the flow rate of nitrogen supplied to a gap between the gate and the process container; the flow rate of nitrogen, at the terminal portion of the process container, supplied to a gap between the process container and the screw; and the pre-mixing method is adopted as the second parameter, a more appropriate processing condition can be determined.

In the machine learning method, the third parameter is preferably at least one of a production amount indicating a processing amount of a raw material forming the resin per unit time; a rotation speed of the screw per unit time; an opening degree of the gate provided in the middle portion of the process container; a pressure at an inlet of the gear pump provided downstream of the resin processing unit; screw power; and specific energy defined by the screw power/the production amount.

According to the present aspect, since at least one of the production amount of the resin; the rotation speed of the screw per unit time; the opening degree of the gate; the pressure at the inlet of the gear pump; the screw power; and the specific energy is adopted as the third parameter, a more appropriate processing condition can be determined.

In the machine learning method, the fourth parameter is preferably at least one of a temperature of the resin at the gate provided in the middle of the process container; a temperature of the resin at the inlet of the gear pump provided downstream of the resin processing unit; a temperature of the resin at an outlet of the gear pump; and a temperature of the resin on an upstream side of the die processing portion included in the pelletizer.

According to the present aspect, since at least one of the temperature of the resin at the gate; the temperature of the resin at the inlet of the gear pump; the temperature of the resin at the outlet of the gear pump; and the temperature of the resin on the upstream side of the die processing portion is adopted as the fourth parameter, a more appropriate processing condition can be determined.

In the machine learning method, the fifth parameter is preferably at least one of a temperature of a first chamber on an upstream side of the resin processing unit; a temperature of a second chamber provided on a downstream side of the first chamber in the resin processing unit; a temperature of a transition piece portion provided between the resin processing unit and the gear pump provided on the downstream side of the resin processing unit; a temperature of the gear pump; a temperature of the screen changer provided on the downstream side of the gear pump; a temperature of the pelletizer; and a temperature of heated oil of the pelletizer.

According to the present aspect, since at least one of the temperature of the first chamber; the temperature of the second chamber; the temperature of the transition piece portion; the temperature of the gear pump; the temperature of the screen changer; the temperature of the pelletizer; and the temperature of the heated oil of the pelletizer is adopted as the fifth parameter, a more appropriate processing condition can be determined.

In the machine learning method, the sixth parameter is preferably at least one of a starting method of the pelletizer; a rotation speed of a knife included in the pelletizer; a pressing force of the knife; a return pressing force of the knife; alignment of the knife; and a temperature of water used to extrude the pellet.

According to the present aspect, since at least one of the starting method of the pelletizer; the rotation speed of the knife of the pelletizer; the pressing force of the knife; the return pressing force of the knife; the alignment of the knife; and the temperature of the water for extruding the pellet is adopted as the sixth parameter, a more appropriate processing condition can be determined.

In the machine learning method, the seventh parameter is preferably at least one of a mechanical vibration frequency of the resin processing device; a number of shutdowns of the resin processing device within 24 hours; a number of shutdowns of the resin processing device for 24 hours or more; an operating time after disassembling and cleaning of the resin processing device; an accumulated operating time for each kind of the resin; an accumulated operating time for each kind of a specific resin; and an accumulated operating time in which the screw operates with power equal to or greater than a threshold value.

According to the present aspect, since at least one of the mechanical vibration frequency of the resin processing device; the number of shutdowns within 24 hours; the number of shutdowns for 24 hours or more; the operating time after disassembling and cleaning; the accumulated operating time for each kind of resin; the accumulated operating time for each kind of a specific resin; and the accumulated operating time in which the screw operates with power equal to or greater than the threshold value is adopted as the seventh parameter, a more appropriate processing condition can be determined.

In the machine learning method, the eighth parameter is preferably at least one of a rotation speed of the gear pump; power of the gear pump; and specific energy that is a value obtained by dividing the gear pump power by a production amount of the resin.

According to the present aspect, since at least one of the rotation speed of the gear pump; the power of the gear pump; and the specific energy that is a value obtained by dividing the power of the gear pump by the production amount of the resin is adopted as the eighth parameter, a more appropriate processing condition can be determined.

In the machine learning method, the function is preferably updated in real time using deep reinforcement learning.

According to the present aspect, since the function is updated in real time using the deep reinforcement learning, the function can be updated accurately and quickly.

Preferably, in the machine learning method, in the calculation of the reward, the reward is increased when the at least one physical quantity approaches a predetermined reference value corresponding to each physical quantity, and the reward is decreased when the at least one physical quantity does not approach the reference value corresponding to each physical quantity.

According to the present aspect, since the reward is increased as the physical quantity approaches the reference value, it is possible to allow the physical quantity to quickly reach the reference value.

In the present invention, each processing included in the machine learning method may be implemented in a machine learning device provided for the machine learning method, or may be implemented and distributed as a machine learning program. The machine learning device may include a server or a resin processing device.

A communication method according to another aspect of the present invention is a communication method of a resin processing device at a time of machine learning of a processing condition for the resin processing device, in which the resin processing device includes a resin processing unit that has a rotating screw and a process container covering the screw, and kneads and outputs a fed resin; a feeder configured to feed the resin to the resin processing unit; and a pelletizer that downstream of the resin processing unit, pelletizes the resin output from the resin processing unit, the communication method including observing a state variable including at least one physical quantity related to a pellet state of the resin and at least one processing condition; and transmitting the state variable over a network and receiving at least one machine-learned processing condition; and in which the at least one processing condition is at least one of a first parameter related to the resin; a second parameter related to the feeder; a third parameter related to an operation condition of the resin processing unit; a fourth parameter related to a kneaded resin; a fifth parameter related to a temperature of the resin processing device; a sixth parameter related to the pelletizer; and a seventh parameter related to an operating status of the resin processing device, and the at least one physical quantity is at least one of kneading quality and pellet quality.

According to the present aspect, information necessary for machine learning of a processing condition is provided. Such a communication method can be implemented also in a resin processing device.

A machine learning method includes acquiring a state variable including a physical quantity related to a pellet state of a resin and a processing condition; calculating a reward for a determination result of the processing condition based on the state variable; updating a function for determining a processing condition from a state variable based on the reward; and repeating updating of the function, thereby determining a processing condition under which the reward can be most obtained.

**Claims**

1.  A machine learning method in which a machine learning device determines a processing condition of a resin processing device (100, 101, 500), wherein
    the resin processing device (100, 101, 500) comprises:

    a resin processing unit (2, 200) that has a rotating screw and a process container (25, 250) covering the screw, and kneads a fed resin and outputs a kneaded resin;
    a feeder (1) configured to feed the resin to the resin processing unit (2, 200); and
    a pelletizer (8) that downstream of the resin processing unit (2, 200), pelletizes the resin output from the resin processing unit (2, 200),
    the machine learning method comprising:

acquiring a state variable including at least one physical quantity related to a pellet state of the resin and at least one processing condition of a first parameter, a second parameter, a third parameter, a fourth parameter, a fifth parameter, a sixth parameter, and a seventh parameter, the first parameter being related to the resin, the second parameter being related to the feeder, the third parameter being related to an operation condition of the resin processing unit, the fourth parameter being related to the kneaded resin, the fifth parameter being related to a temperature of the resin processing device, the sixth parameter being related to the pelletizer, and the seventh parameter being related to an operating status of the resin processing device;

calculating a reward for a determination result of the at least one processing condition based on the state variable;

updating a function for determining the at least one processing condition from the state variable based on the reward; and determining, among the first parameter, the second parameter, the third parameter, the fourth parameter, the fifth parameter, the sixth parameter, and

the seventh parameter, at least one processing condition under which the reward is most obtained by repeating updating of the function; and

wherein the at least one physical quantity is at least one of kneading quality and pellet quality,

**characterized in that**

the third parameter is at least one of a production amount indicating a processing amount of a raw material forming the resin per unit time; a rotation speed of the screw per unit time; an opening degree of the gate provided in the middle portion of the process container (25, 250); a pressure at an inlet of the gear pump (6) provided downstream of the resin processing unit (2, 200); screw power; and specific energy defined by the screw power/the production amount, and

the seventh parameter is at least one of a mechanical vibration frequency of the resin processing device (100, 101, 500); a number of shutdowns of the resin processing device (100, 101, 500) within 24 hours; a number of shutdowns of the resin processing device (100, 101, 500) for 24 hours or more; an operating time after disassembling and cleaning of the resin processing device (100, 101, 500); an accumulated operating time for each kind of the resin; an accumulated operating time for each kind of a specific resin; and an accumulated operating time in which the screw operates with power equal to or greater than a threshold value.

2. The machine learning method according to claim 1, wherein

the resin processing device (100, 101, 500) further comprises a gear pump (6) that is provided between the resin processing unit (2, 200) and the pelletizer (8) and pulls out a kneaded resin from the resin processing unit (2, 200), and

the at least one processing condition further includes an eighth parameter related to the gear pump (6).

3. The machine learning method according to claim 1, wherein the first parameter is at least one of a before screen changer resin pressure that indicates a pressure of a resin at an inlet of a screen changer (7) that is provided downstream of the resin processing unit (2, 200) and filters impurities in the resin; a before die resin pressure that indicates a pressure of the resin at an inlet of a die processing portion included in the pelletizer (8); a differential pressure of the resin between the inlet and an outlet of the screen changer (7); and a screen size that indicates fineness of a mesh of the screen changer (7).

4. The machine learning method according to claim 1, wherein
the second parameter is at least one of:
a raw material molecular weight distribution indicating a distribution of molecular weights of one or more raw materials constituting the resin; a raw material MI; a raw material particle size distribution; a raw material temperature; an oxygen concentration in a hopper included in the feeder (1); a nitrogen flow rate in the hopper; a flow rate of nitrogen, at a distal end portion of the process container (25, 250), supplied to a gap between the screw and the process container (25, 250); a flow rate of nitrogen supplied to a gap between a gate provided in a middle portion of the process container (25, 250) and the process container (25, 250); a flow rate of nitrogen, at a terminal portion of the process container (25, 250), supplied to a gap between the process container (25, 250) and the screw; and a pre-mixing method of mixing the at least one raw material and an additive before being charged into the resin processing unit (2, 200).

5. The machine learning method according to claim 1, wherein the fourth parameter is at least one of a temperature of the resin at the gate provided in the middle of the process container (25, 250); a temperature of the resin at the inlet of the gear pump (6) provided downstream of the resin processing unit (2, 20 200); a temperature of the resin at an outlet of the gear pump (6); and a temperature of the resin on an upstream side of the die processing portion included in the pelletizer (8).

6.  The machine learning method according to claim 1, wherein the fifth parameter is at least one of a temperature of a first chamber on an upstream side of the resin processing unit (200); a temperature of a second chamber provided on a downstream side of the first chamber in the resin processing unit (200); a temperature of a transition piece portion provided between the resin processing unit (200) and the gear pump (6) provided on the downstream side of the resin processing unit (200); a temperature of the gear pump (6); a temperature of the screen changer (7) provided on the downstream side of the gear pump (6); a temperature of the pelletizer (8); and a temperature of heated oil of the pelletizer (8).

7.  The machine learning method according to claim 1, wherein the sixth parameter is at least one of a starting method of the pelletizer (8); a rotation speed of a knife included in the pelletizer (8); a pressing force of the knife; a return pressing force of the knife; alignment of the knife; and a temperature of water used to extrude the pellet.

8.  The machine learning method according to claim 2, wherein the eighth parameter is at least one of a rotation speed of the gear pump (6); power of the gear pump (6); and specific energy that is a value obtained by dividing the gear pump power by a production amount of the resin.

9.  The machine learning method according to claim 1, wherein the function is updated in real time using deep reinforcement learning.

10. The machine learning method according to any one of claims 1 to 9, wherein in the calculation of the reward, the reward is increased when the at least one physical quantity approaches a predetermined reference value corresponding to each physical quantity, and the reward is decreased when the at least one physical quantity does not approach the reference value corresponding to each physical quantity.

11. A machine learning device that determines a processing condition of a resin processing device (100, 101, 500), wherein the resin processing device (100, 101, 500) comprises:

    a resin processing unit (2, 200) that has a rotating screw and a process container (25, 250) covering the screw, and kneads a fed resin and outputs a kneaded resin;
    a feeder (1) configured to feed the resin to the resin processing unit (2, 200); and
    a pelletizer (8) that downstream of the resin processing unit (2, 200), pelletizes the resin output from the resin processing unit (2, 200),
    the machine learning device comprising:

    a state acquisition portion (420) that acquires a state variable including at least one physical quantity related to a pellet state of the resin and at least one processing condition of a first parameter, a second parameter, a third parameter, a fourth parameter, a fifth parameter, a sixth parameter, and a seventh parameter, the first parameter being related to the resin, the second parameter being related to the feeder, the third parameter being related to an operation condition of the resin processing unit, the fourth parameter being related to the kneaded resin, the fifth parameter being related to a temperature of the resin processing device, the sixth parameter being related to the pelletizer, and the seventh parameter being related to an operating status of the resin processing device;
    a reward calculation portion (411) that calculates a reward for a determination result of the at least one processing condition based on the state variable;
    an update portion (412) that updates a function for determining the at least one processing condition from the state variable based on the reward; and
    a determination portion (413) that determines, among the first parameter, the second parameter, the third parameter, the fourth parameter, the fifth parameter, the sixth parameter, and the seventh parameter, at least one processing condition under which the reward is most obtained by repeating updating of the function, and wherein
    the at least one physical quantity is at least one of kneading quality and pellet quality,
    **characterized in that**
    the third parameter is at least one of a production amount indicating a processing amount of a raw material forming the resin per unit time; a rotation speed of the screw per unit time; an opening degree of the gate provided in the middle portion of the process container (25, 250); a pressure at an inlet of the gear pump (6) provided downstream of the resin processing unit (2, 200); screw power; and specific energy defined by the screw power/the production amount, and

the seventh parameter is at least one of a mechanical vibration frequency of the resin processing device (100, 101, 500); a number of shutdowns of the resin processing device (100, 101, 500) within 24 hours; a number of shutdowns of the resin processing device (100, 101, 500) for 24 hours or more; an operating time after disassembling and cleaning of the resin processing device (100, 101, 500); an accumulated operating time for each kind of the resin; an accumulated operating time for each kind of a specific resin; and an accumulated operating time in which the screw operates with power equal to or greater than a threshold value.

12. A machine learning program of a machine learning device that determines a processing condition of a resin processing device (100, 101, 500), wherein

the resin processing device (100, 101, 500) comprises:

a resin processing unit (2, 200) that has a rotating screw and a process container (25, 250) covering the screw, and kneads a fed resin and outputs a kneaded resin;
a feeder (1) configured to feed the resin to the resin processing unit (2, 200); and
a pelletizer (8) that downstream of the resin processing unit (2, 200), pelletizes the resin output from the resin processing unit (2, 200),
the machine learning program causing a computer to function as:

a state acquisition portion (420) that acquires a state variable including at least one physical quantity related to a pellet state of the resin and at least one processing condition of a first parameter, a second parameter, a third parameter, a fourth parameter, a fifth parameter, a sixth parameter, and a seventh parameter, the first parameter being related to the resin, the second parameter being related to the feeder, the third parameter being related to an operation condition of the resin processing unit, the fourth parameter being related to the kneaded resin, the fifth parameter being related to a temperature of the resin processing device, the sixth parameter being related to the pelletizer, and the seventh parameter being related to an operating status of the resin processing device;
a reward calculation portion (411) that calculates a reward for a determination result of the at least one processing condition based on the state variable;
an update portion (412) that updates a function for determining the at least one processing condition from the state variable based on the reward; and
a determination portion (413) that determines, among the first parameter, the second parameter, the third parameter, the fourth parameter, the fifth parameter, the sixth parameter, and the seventh parameter, at least one processing condition under which the reward is most obtained by repeating updating of the function, and wherein
the at least one physical quantity is at least one of kneading quality and pellet quality,
**characterized in that**
the third parameter is at least one of a production amount indicating a processing amount of a raw material forming the resin per unit time; a rotation speed of the screw per unit time; an opening degree of the gate provided in the middle portion of the process container (25, 250); a pressure at an inlet of the gear pump (6) provided downstream of the resin processing unit (2, 200); screw power; and specific energy defined by the screw power/the production amount, and
the seventh parameter is at least one of a mechanical vibration frequency of the resin processing device (100, 101, 500); a number of shutdowns of the resin processing device (100, 101, 500) within 24 hours; a number of shutdowns of the resin processing device (100, 101, 500) for 24 hours or more; an operating time after disassembling and cleaning of the resin processing device (100, 101, 500); an accumulated operating time for each kind of the resin; an accumulated operating time for each kind of a specific resin; and an accumulated operating time in which the screw operates with power equal to or greater than a threshold value.

**Patentansprüche**

1. Maschinenlernverfahren, bei dem eine Maschinenlerneinrichtung eine Verarbeitungsbedingung einer Harzverarbeitungseinrichtung (100, 101, 500) bestimmt, wobei

die Harzverarbeitungseinrichtung (100, 101, 500) aufweist:

eine Harzverarbeitungseinheit (2, 200), die eine rotierende Schnecke und einen Prozessbehälter (25, 250) aufweist, der die Schnecke abdeckt, und ein zugeführtes Harz knetet und ein geknetetes Harz ausgibt;
eine Zuführeinrichtung (1), die dazu konfiguriert ist, das Harz der Harzverarbeitungseinheit (2, 200) zuzuführen; und
einen Pelletierer (8), der stromabwärts der Harzverarbeitungseinheit (2, 200) das von der Harzverarbeitungseinheit (2, 200) ausgegebene Harz pelletiert,
wobei das Maschinenlernverfahren aufweist:

Beschaffen einer Zustandsvariablen, die mindestens eine physikalische Größe, die sich auf einen Pelletzustand des Harzes bezieht, und mindestens eine Verarbeitungsbedingung eines ersten Parameters, eines zweiten Parameters, eines dritten Parameters, eines vierten Parameters, eines fünften Parameters, eines sechsten Parameters und eines siebten Parameters umfasst, wobei sich der erste Parameter auf das Harz bezieht, der zweite Parameter sich auf die Zuführeinrichtung bezieht, der dritte Parameter sich auf eine Operationsbedingung der Harzverarbeitungseinheit bezieht, der vierte Parameter sich auf das geknetete Harz bezieht, der fünfte Parameter sich auf eine Temperatur der Harzverarbeitungseinrichtung bezieht, der sechste Parameter sich auf den Pelletierer bezieht und der siebte Parameter sich auf einen Betriebszustand der Harzverarbeitungseinrichtung bezieht;
Berechnen einer Belohnung für ein Bestimmungsergebnis der mindestens einen Verarbeitungsbedingung basierend auf der Zustandsvariablen;
Aktualisieren einer Funktion zum Bestimmen der mindestens einen Verarbeitungsbedingung aus der Zustandsvariablen basierend auf der Belohnung; und Bestimmen, unter dem ersten Parameter, dem zweiten Parameter, dem dritten Parameter, dem vierten Parameter, dem fünften Parameter, dem sechsten Parameter, und
dem siebten Parameter mindestens einer Verarbeitungsbedingung, unter der die Belohnung am meisten erhalten wird, durch wiederholtes Aktualisieren der Funktion; und
wobei die mindestens eine physikalische Größe mindestens eines von Knetqualität und Pelletqualität ist, **dadurch gekennzeichnet, dass**
der dritte Parameter mindestens einer einer Produktionsmenge, die eine Verarbeitungsmenge eines das Harz bildenden Rohmaterials pro Zeiteinheit angibt; einer Rotationsgeschwindigkeit der Schnecke pro Zeiteinheit; eines Öffnungsgrades des im mittleren Abschnitt des Prozessbehälters (25, 250) vorgesehenen Verschlusses; eines Drucks an einem Einlass der stromabwärts der Harzverarbeitungseinheit (2, 200) vorgesehenen Zahnradpumpe (6); einer Schneckenleistung; und einer spezifischen Energie, die durch die Schneckenleistung/die Produktionsmenge definiert ist, ist, und
der siebte Parameter mindestens einer einer mechanischen Vibrationsfrequenz der Harzverarbeitungseinrichtung (100, 101, 500); einer Anzahl von Abschaltungen der Harzverarbeitungseinrichtung (100, 101, 500) innerhalb von 24 Stunden; einer Anzahl von Abschaltungen der Harzverarbeitungseinrichtung (100, 101, 500) für 24 Stunden oder mehr; einer Betriebszeit nach dem Zerlegen und Reinigen der Harzverarbeitungseinrichtung (100, 101, 500); einer akkumulierten Betriebszeit für jede Art des Harzes; einer akkumulierten Betriebszeit für jede Art eines spezifischen Harzes; und einer akkumulierten Betriebszeit, in der die Schnecke mit einer Leistung arbeitet, die gleich oder größer als ein Schwellenwert ist, ist.

2. Das Maschinenlernverfahren gemäß Anspruch 1, wobei

die Harzverarbeitungseinrichtung (100, 101, 500) weiterhin eine Zahnradpumpe (6) umfasst, die zwischen der Harzverarbeitungseinheit (2, 200) und dem Pelletierer (8) vorgesehen ist und ein geknetetes Harz aus der Harzverarbeitungseinheit (2, 200) herauszieht, und
die mindestens eine Verarbeitungsbedingung weiterhin einen achten Parameter umfasst, der sich auf die Zahnradpumpe (6) bezieht.

3. Maschinenlernverfahren gemäß Anspruch 1, wobei der erste Parameter mindestens einer eines Harzdrucks vor dem Siebwechsler, der einen Druck eines Harzes an einem Einlass eines Siebwechslers (7) anzeigt, der stromabwärts der Harzverarbeitungseinheit (2, 200) vorgesehen ist und Verunreinigungen im Harz filtert; eines Harzdrucks vor der Matrize, der einen Druck des Harzes an einem Einlass eines in dem Pelletierer (8) enthaltenen Matrizenverarbeitungsabschnitts angibt; eines Differenzdrucks des Harzes zwischen dem Einlass und einem Auslass des Siebwechslers (7); und einer Siebgröße, die die Feinheit eines Gewebes des Siebwechslers (7) angibt, ist.

4. Maschinenlernverfahren gemäß Anspruch 1, wobei
der zweite Parameter mindestens einer ist von:
einer Rohmaterial-Molekulargewichtsverteilung, die eine Verteilung der Molekulargewichte eines oder mehrerer Rohmaterialien angibt, aus denen das Harz besteht; einer Rohmaterial-MI; einer Rohmaterial-Partikelgrößenverteilung; einer Rohmaterial-Temperatur; einer Sauerstoffkonzentration in einem Trichter, der in der Zuführeinrichtung (1) enthalten ist; einer Stickstoff-Durchflussrate in dem Trichter; einer Durchflussrate von Stickstoff an einem distalen Endabschnitt des Prozessbehälters (25, 250), der einem Spalt zwischen der Schnecke und dem Prozessbehälter (25, 250) zugeführt wird; eine Durchflussrate von Stickstoff, der einem Spalt zwischen einem in einem mittleren Abschnitt des Prozessbehälters (25, 250) vorgesehenen Verschlusses und dem Prozessbehälter (25, 250) zugeführt wird; eine Durchflussrate von Stickstoff an einem Anschlussabschnitt des Prozessbehälters (25, 250), der einem Spalt zwischen dem Prozessbehälter (25, 250) und der Schnecke zugeführt wird; und ein Vormischverfahren zum Mischen des mindestens einen Rohmaterials und eines Additivs, vor einem Einladen in die Harzverarbeitungseinheit (2, 200).

5. Maschinenlernverfahren gemäß Anspruch 1, wobei der vierte Parameter mindestens einer einer Temperatur des Harzes an dem in der Mitte des Prozessbehälters (25, 250) vorgesehenen Verschlusses; einer Temperatur des Harzes am Einlass der stromabwärts der Harzverarbeitungseinheit (2, 20, 200) vorgesehenen Zahnradpumpe (6); einer Temperatur des Harzes an einem Auslass der Zahnradpumpe (6); und einer Temperatur des Harzes an einer stromaufwärts gelegenen Seite des in dem Pelletierer (8) enthaltenen Matrizenverarbeitungsabschnitts ist.

6. Maschinenlernverfahren gemäß Anspruch 1, wobei der fünfte Parameter mindestens einer einer Temperatur einer ersten Kammer auf einer stromaufwärtigen Seite der Harzverarbeitungseinheit (200); einer Temperatur einer zweiten Kammer, die auf einer stromabwärtigen Seite der ersten Kammer in der Harzverarbeitungseinheit (200) vorgesehen ist; einer Temperatur eines Übergangsstückabschnitts, der zwischen der Harzverarbeitungseinheit (200) und der Zahnradpumpe (6) vorgesehen ist, die auf der stromabwärtigen Seite der Harzverarbeitungseinheit (200) vorgesehen ist; einer Temperatur der Zahnradpumpe (6); einer Temperatur des Siebwechslers (7), der auf der stromabwärtigen Seite der Zahnradpumpe (6) vorgesehen ist; einer Temperatur des Pelletierers (8); und einer Temperatur des erhitzten Öls des Pelletierers (8).

7. Maschinenlernverfahren gemäß Anspruch 1, wobei der sechste Parameter mindestens einer eines Startverfahren des Pelletierers (8); einer Rotationsgeschwindigkeit eines im Pelletierer (8) enthaltenen Messers; einer Presskraft des Messers; einer Rückpresskraft des Messers; einer Ausrichtung des Messers; und einer Temperatur des zum Extrudieren des Pellets verwendeten Wassers ist.

8. Maschinenlernverfahren gemäß Anspruch 2, wobei der achte Parameter mindestens einer einer Drehzahl der Zahnradpumpe (6); einer Leistung der Zahnradpumpe (6); und einer spezifischen Energie, die ein Wert ist, der durch Dividieren der Zahnradpumpenleistung durch eine Produktionsmenge des Harzes erhalten wird, ist.

9. Maschinenlernverfahren gemäß Anspruch 1, wobei die Funktion in Echtzeit unter Verwendung von Deep Reinforcement Learning aktualisiert wird.

10. Maschinenlernverfahren gemäß einem der Ansprüche 1 bis 9, wobei bei der Berechnung der Belohnung die Belohnung erhöht wird, wenn sich die mindestens eine physikalische Größe einem vorgegebenen Referenzwert nähert, der jeder physikalischen Größe entspricht, und die Belohnung verringert wird, wenn sich die mindestens eine physikalische Größe nicht dem Referenzwert nähert, der jeder physikalischen Größe entspricht.

11. Maschinenlerneinrichtung, die eine Verarbeitungsbedingung einer Harzverarbeitungseinrichtung (100, 101, 500) bestimmt, wobei
die Harzverarbeitungseinrichtung (100, 101, 500) aufweist:

eine Harzverarbeitungseinheit (2, 200), die eine rotierende Schnecke und einen Prozessbehälter (25, 250) aufweist, der die Schnecke abdeckt, und ein zugeführtes Harz knetet und ein geknetetes Harz ausgibt;
eine Zuführeinrichtung (1), die dazu konfiguriert ist, das Harz der Harzverarbeitungseinheit (2, 200) zuzuführen; und
einen Pelletierer (8), der stromabwärts der Harzverarbeitungseinheit (2, 200) das von der Harzverarbeitungseinheit (2, 200) ausgegebene Harz pelletiert,
wobei die Maschinenlerneinrichtung aufweist:

einen Zustandsbeschaffungsabschnitt (420), der eine Zustandsvariable beschafft, die mindestens eine physikalische Größe, die sich auf einen Pelletzustand des Harzes bezieht, und mindestens eine Verarbeitungbedingung eines ersten Parameters, eines zweiten Parameters, eines dritten Parameters, eines vierten Parameters, eines fünften Parameters, eines sechsten Parameters und eines siebten Parameters umfasst, wobei sich der erste Parameter auf das Harz bezieht, der zweite Parameter sich auf die Zuführeinrichtung bezieht, der dritte Parameter sich auf eine Operationsbedingung der Harzverarbeitungseinheit bezieht, der vierte Parameter sich auf das geknetete Harz bezieht, der fünfte Parameter sich auf eine Temperatur der Harzverarbeitungseinrichtung bezieht, der sechste Parameter sich auf den Pelletierer bezieht und der siebte Parameter sich auf einen Betriebszustand der Harzverarbeitungseinrichtung bezieht;

einen Belohnungsberechnungsabschnitt (411), der eine Belohnung für ein Bestimmungsergebnis der mindestens einen Verarbeitungsbedingung basierend auf der Zustandsvariablen berechnet;

einen Aktualisierungsabschnitt (41), der eine Funktion zum Bestimmen der mindestens einen Verarbeitungsbedingung aus der Zustandsvariablen basierend auf der Belohnung aktualisiert; und

einen Bestimmungsabschnitt (413), der unter dem ersten Parameter, dem zweiten Parameter, dem dritten Parameter, dem vierten Parameter, dem fünften Parameter, dem sechsten Parameter, und dem siebten Parameter mindestens eine Verarbeitungsbedingung, unter der die Belohnung am meisten erhalten wird, durch wiederholtes Aktualisieren der Funktion bestimmt; und wobei

die mindestens eine physikalische Größe mindestens eines von Knetqualität und Pelletqualität ist, **dadurch gekennzeichnet, dass**

der dritte Parameter mindestens einer einer Produktionsmenge, die eine Verarbeitungsmenge eines das Harz bildenden Rohmaterials pro Zeiteinheit angibt; einer Rotationsgeschwindigkeit der Schnecke pro Zeiteinheit; eines Öffnungsgrades des im mittleren Abschnitt des Prozessbehälters (25, 250) vorgesehenen Verschlusses; eines Drucks an einem Einlass der stromabwärts der Harzverarbeitungseinheit (2, 200) vorgesehenen Zahnradpumpe (6); einer Schneckenleistung; und einer spezifischen Energie, die durch die Schneckenleistung/die Produktionsmenge definiert ist, ist, und

der siebte Parameter mindestens einer einer mechanischen Vibrationsfrequenz der Harzverarbeitungseinrichtung (100, 101, 500); einer Anzahl von Abschaltungen der Harzverarbeitungseinrichtung (100, 101, 500) innerhalb von 24 Stunden; einer Anzahl von Abschaltungen der Harzverarbeitungseinrichtung (100, 101, 500) für 24 Stunden oder mehr; einer Betriebszeit nach dem Zerlegen und Reinigen der Harzverarbeitungseinrichtung (100, 101, 500); einer akkumulierten Betriebszeit für jede Art des Harzes; einer akkumulierten Betriebszeit für jede Art eines spezifischen Harzes; und einer akkumulierten Betriebszeit, in der die Schnecke mit einer Leistung arbeitet, die gleich oder größer als ein Schwellenwert ist, ist.

12. Maschinenlernprogramm einer Maschinenlerneinrichtung, die eine Verarbeitungsbedingung einer Harzverarbeitungseinrichtung (100, 101, 500) bestimmt, wobei
die Harzverarbeitungseinrichtung (100, 101, 500) aufweist:

eine Harzverarbeitungseinheit (2, 200), die eine rotierende Schnecke und einen Prozessbehälter (25, 250) aufweist, der die Schnecke abdeckt, und ein zugeführtes Harz knetet und ein geknetetes Harz ausgibt;

eine Zuführeinrichtung (1), die dazu konfiguriert ist, das Harz der Harzverarbeitungseinheit (2, 200) zuzuführen; und

einen Pelletierer (8), der stromabwärts der Harzverarbeitungseinheit (2, 200) das von der Harzverarbeitungseinheit (2, 200) ausgegebene Harz pelletiert,

wobei die Maschinenlernprogramm einen Computer veranlasst, um zu arbeiten als:

ein Zustandsbeschaffungsabschnitt (420), der eine Zustandsvariable beschafft, die mindestens eine physikalische Größe, die sich auf einen Pelletzustand des Harzes bezieht, und mindestens eine Verarbeitungsbedingung eines ersten Parameters, eines zweiten Parameters, eines dritten Parameters, eines vierten Parameters, eines fünften Parameters, eines sechsten Parameters und eines siebten Parameters umfasst, wobei sich der erste Parameter auf das Harz bezieht, der zweite Parameter sich auf die Zuführeinrichtung bezieht, der dritte Parameter sich auf eine Operationsbedingung der Harzverarbeitungseinheit bezieht, der vierte Parameter sich auf das geknetete Harz bezieht, der fünfte Parameter sich auf eine Temperatur der Harzverarbeitungseinrichtung bezieht, der sechste Parameter sich auf den Pelletierer bezieht und der siebte Parameter sich auf einen Betriebszustand der Harzverarbeitungseinrichtung bezieht;

ein Belohnungsberechnungsabschnitt (411), der eine Belohnung für ein Bestimmungsergebnis der mindestens einen Verarbeitungsbedingung basierend auf der Zustandsvariablen berechnet;

ein Aktualisierungsabschnitt (41), der eine Funktion zum Bestimmen der mindestens einen Verarbeitungsbedingung aus der Zustandsvariablen basierend auf der Belohnung aktualisiert; und

ein Bestimmungsabschnitt (413), der unter dem ersten Parameter, dem zweiten Parameter, dem dritten Parameter, dem vierten Parameter, dem fünften Parameter, dem sechsten Parameter, und dem siebten Parameter mindestens eine Verarbeitungsbedingung, unter der die Belohnung am meisten erhalten wird, durch wiederholtes Aktualisieren der Funktion bestimmt; und wobei

die mindestens eine physikalische Größe mindestens eines von Knetqualität und Pelletqualität ist, **dadurch gekennzeichnet, dass**

der dritte Parameter mindestens einer einer Produktionsmenge, die eine Verarbeitungsmenge eines das Harz bildenden Rohmaterials pro Zeiteinheit angibt; einer Rotationsgeschwindigkeit der Schnecke pro Zeiteinheit; eines Öffnungsgrades des im mittleren Abschnitt des Prozessbehälters (25, 250) vorgesehenen Verschlusses; eines Drucks an einem Einlass der stromabwärts der Harzverarbeitungseinheit (2, 200) vorgesehenen Zahnradpumpe (6); einer Schneckenleistung; und einer spezifischen Energie, die durch die Schneckenleistung/die Produktionsmenge definiert ist, ist, und

der siebte Parameter mindestens einer einer mechanischen Vibrationsfrequenz der Harzverarbeitungseinrichtung (100, 101, 500); einer Anzahl von Abschaltungen der Harzverarbeitungseinrichtung (100, 101, 500) innerhalb von 24 Stunden; einer Anzahl von Abschaltungen der Harzverarbeitungseinrichtung (100, 101, 500) für 24 Stunden oder mehr; einer Betriebszeit nach dem Zerlegen und Reinigen der Harzverarbeitungseinrichtung (100, 101, 500); einer akkumulierten Betriebszeit für jede Art des Harzes; einer akkumulierten Betriebszeit für jede Art eines spezifischen Harzes; und einer akkumulierten Betriebszeit, in der die Schnecke mit einer Leistung arbeitet, die gleich oder größer als ein Schwellenwert ist, ist.

## Revendications

1. Procédé d'apprentissage automatique dans lequel un dispositif d'apprentissage automatique détermine une condition de traitement d'un dispositif de traitement de résine (100, 101, 500), le dispositif de traitement de résine (100, 101, 500) comprenant :

   une unité de traitement de résine (2, 200) qui a une vis rotative et un récipient de traitement (25, 250) recouvrant la vis, et qui malaxe une résine alimentée et sort une résine malaxée ;
   un alimentateur (1) configuré pour alimenter une résine à l'unité de traitement de résine (2, 200) ; et
   un granulateur (8) qui, en aval de l'unité de traitement de résine (2, 200), granule la résine émise de l'unité de traitement de résine (2, 200),
   le procédé d'apprentissage automatique comprenant :

   l'acquisition d'une variable d'état comportant au moins une quantité physique liée à un état de granulation de la résine et au moins une condition de traitement d'un premier paramètre, d'un deuxième paramètre, d'un troisième paramètre, d'un quatrième paramètre, d'un cinquième paramètre, d'un sixième paramètre et d'un septième paramètre, le premier paramètre étant lié à la résine, le deuxième paramètre étant lié au alimentateur, le troisième paramètre étant lié à un état de fonctionnement de l'unité de traitement de résine, le quatrième paramètre étant lié à la résine malaxée, le cinquième paramètre étant lié à une température du dispositif de traitement de résine, le sixième paramètre étant lié au granulateur, et le septième paramètre étant lié à un état de fonctionnement du dispositif de traitement de résine ;
   le calcul d'une récompense pour un résultat de détermination de l'au moins une condition de traitement sur la base de la variable d'état ;
   la mise à jour d'une fonction de détermination de l'au moins une condition de traitement à partir de la variable d'état sur la base de la récompense ; et la détermination, parmi le premier paramètre, le deuxième paramètre, le troisième paramètre, le quatrième paramètre, le cinquième paramètre, le sixième paramètre, et le septième paramètre, de l'au moins une condition de traitement dans laquelle la récompense est la plus obtenue en répétant la mise à jour de la fonction ; et l'au moins une quantité physique étant au moins l'une parmi la qualité du malaxage et la qualité du granulé,
   **caractérisé en ce que**
   le troisième paramètre est au moins l'un des suivants : une quantité de production indiquant une quantité de traitement d'une matière première formant la résine par unité de temps ; une vitesse de rotation de la vis par unité de temps ; un degré d'ouverture de la porte prévue dans la partie centrale du récipient de traitement (25, 250) ; une pression à une entrée de la pompe à engrenages (6) prévue en aval de l'unité de traitement de résine (2, 200) ; la puissance de la vis ; et l'énergie spécifique définie par la puissance de la vis/la quantité de production, et
   le septième paramètre est au moins l'un des suivants : une fréquence de vibration mécanique du dispositif de traitement de résine (100, 101, 500) ; un nombre d'arrêts du dispositif de traitement de résine (100, 101, 500) dans les 24 heures ; un nombre d'arrêts du dispositif de traitement de résine (100, 101, 500) pendant 24 heures ou plus ; un temps de fonctionnement après le démontage et le nettoyage du dispositif de traitement de résine (100, 101, 500) ; un temps de fonctionnement cumulé pour chaque type de la résine ; un temps de fonctionnement cumulé pour chaque type d'une résine spécifique ; et un temps de fonctionnement cumulé pendant lequel la vis fonctionne avec une puissance égale ou supérieure à une valeur seuil.

2.  Procédé d'apprentissage automatique selon la revendication 1, dans lequel

    le dispositif de traitement de résine (100, 101, 500) comprend en outre une pompe à engrenages (6) qui est fournie entre l'unité de traitement de résine (2, 200) et le granulateur (8) et retire une résine malaxée de l'unité de traitement de résine (2, 200), et
    l'au moins une condition de traitement comporte en outre un huitième paramètre lié à la pompe à engrenages (6).

3.  Procédé d'apprentissage automatique selon la revendication 1, dans lequel le premier paramètre est au moins l'un des suivants : une pression de résine avant le changeur de tamis qui indique une pression d'une résine à une entrée d'un changeur de tamis (7) qui est fourni en aval de l'unité de traitement de résine (2, 200) et qui filtre des impuretés dans la résine ; une pression de résine avant la matrice qui indique une pression de la résine à une entrée d'une partie de traitement de matrice incluse dans le granulateur (8) ; une pression différentielle de la résine entre l'entrée et une sortie du changeur de tamis (7) ; et une taille de tamis qui indique la finesse d'une maille du changeur de tamis (7).

4.  Procédé d'apprentissage automatique selon la revendication 1, dans lequel
    le deuxième paramètre est au moins l'un des suivants :

    une distribution des poids moléculaires des matières premières indiquant une distribution des poids moléculaires d'une ou plusieurs matières premières constituant la résine ; un MI des matières premières ; une distribution de la taille des particules des matières premières ; une température des matières premières ; une concentration d'oxygène dans une trémie incluse dans l'alimentateur (1) ; un débit d'azote dans la trémie ; un débit d'azote, à une partie d'extrémité distale du récipient de traitement (25, 250), fourni à un espace entre la vis et le récipient de traitement (25, 250) ; un débit d'azote fourni à un espace entre une porte prévue dans une partie centrale du récipient de traitement (25, 250) et le récipient de traitement (25, 250) ; un débit d'azote, à une partie terminale du récipient de traitement (25, 250), fourni à un espace entre le récipient de traitement (25, 250) et la vis ; et un procédé de pré-mélange consistant à mélanger la au moins une matière première et un additif avant d'être chargés dans l'unité de traitement de résine (2, 200).

5.  Procédé d'apprentissage automatique selon la revendication 1, dans lequel le quatrième paramètre est au moins l'un parmi une température de la résine à la porte prévue au milieu du récipient de traitement (25, 250) ; une température de la résine à l'entrée de la pompe à engrenages (6) prévue en aval de l'unité de traitement de résine (2, 20 200) ; une température de la résine à une sortie de la pompe à engrenages (6) ; et une température de la résine sur un côté en amont de la partie de traitement de la matrice incluse dans le granulateur (8).

6.  Procédé d'apprentissage automatique selon la revendication 1, dans lequel le cinquième paramètre est au moins l'un des suivants : une température d'une première chambre sur un côté amont de l'unité de traitement de résine (200) ; une température d'une deuxième chambre prévue sur un côté aval de la première chambre dans l'unité de traitement de résine (200) ; une température d'une partie de pièce de transition prévue entre l'unité de traitement de résine (200) et la pompe à engrenages (6) prévue sur le côté aval de l'unité de traitement de résine (200) ; une température de la pompe à engrenages (6) ; une température du changeur de tamis (7) prévu sur le côté aval de la pompe à engrenages (6) ; une température du granulateur (8) ; et une température de l'huile chauffée du granulateur (8).

7.  Procédé d'apprentissage automatique selon la revendication 1, dans lequel le sixième paramètre est au moins l'un parmi un procédé de démarrage du granulateur (8) ; une vitesse de rotation d'un couteau inclus dans le granulateur (8) ; une force de pression du couteau ; une force de pression de retour du couteau ; l'alignement du couteau ; et une température de l'eau utilisée pour extruder le granulé.

8.  Procédé d'apprentissage automatique selon la revendication 2, dans lequel le huitième paramètre est au moins l'un parmi une vitesse de rotation de la pompe à engrenages (6) ; la puissance de la pompe à engrenages (6) ; et une énergie spécifique qui est une valeur obtenue en divisant la puissance de la pompe à engrenages par une quantité de production de la résine.

9. Procédé d'apprentissage automatique selon la revendication 1, dans lequel la fonction est mise à jour en temps réel en utilisant l'apprentissage par renforcement profond.

10. Procédé d'apprentissage automatique selon l'une des revendications 1 à 9, dans lequel, dans le calcul de la récompense, la récompense est augmentée lorsque l'au moins une quantité physique s'approche d'une valeur de référence prédéterminée correspondant à chaque quantité physique, et la récompense est diminuée lorsque l'au moins une quantité physique ne s'approche pas de la valeur de référence correspondant à chaque quantité physique.

11. Dispositif d'apprentissage automatique qui détermine une condition de traitement d'un dispositif de traitement de résine (100, 101, 500), dans lequel le dispositif de traitement de résine (100, 101, 500) comprend :

une unité de traitement de résine (2, 200) qui a une vis rotative et un récipient de traitement (25, 250) recouvrant la vis, et qui malaxe une résine alimentée et sort une résine malaxée ;
un alimentateur (1) configuré pour alimenter la résine à l'unité de traitement de résine (2, 200) ; et
un granulateur (8) qui, en aval de l'unité de traitement de résine (2, 200), granule la résine émise de l'unité de traitement de résine (2, 200),
le dispositif d'apprentissage automatique comprenant :

une partie d'acquisition d'état (420) qui acquiert une variable d'état comportant au moins une quantité physique liée à un état de granulation de la résine et au moins une condition de traitement d'un premier paramètre, d'un deuxième paramètre, d'un troisième paramètre, d'un quatrième paramètre, d'un cinquième paramètre, d'un sixième paramètre et d'un septième paramètre, le premier paramètre étant lié à la résine, le deuxième paramètre étant lié au alimentateur, le troisième paramètre étant lié à un état de fonctionnement de l'unité de traitement de résine, le quatrième paramètre étant lié à la résine malaxée, le cinquième paramètre étant lié à une température du dispositif de traitement de résine, le sixième paramètre étant lié au granulateur, et le septième paramètre étant lié à un état de fonctionnement du dispositif de traitement de résine ;
une partie de calcul de récompense (411) qui calcule une récompense pour un résultat de détermination de l'au moins une condition de traitement sur la base de la variable d'état ;
une partie de mise à jour (412) qui met à jour une fonction de détermination de l'au moins une condition de traitement à partir de la variable d'état sur la base de la récompense ; et
une partie de détermination (413) qui détermine, parmi le premier paramètre, le deuxième paramètre, le troisième paramètre, le quatrième paramètre, le cinquième paramètre, le sixième paramètre et le septième paramètre, au moins une condition de traitement dans laquelle la récompense est la plus obtenue en répétant la mise à jour de la fonction, et dans lequel
l'au moins une quantité physique est au moins l'une parmi la qualité du malaxage et la qualité du granulé,
**caractérisé en ce que**
le troisième paramètre est au moins l'un des suivants : une quantité de production indiquant une quantité de traitement d'une matière première formant la résine par unité de temps ; une vitesse de rotation de la vis par unité de temps ; un degré d'ouverture de la porte prévue dans la partie centrale du récipient de traitement (25, 250) ; une pression à une entrée de la pompe à engrenages (6) prévue en aval de l'unité de traitement de résine (2, 200) ; la puissance de la vis ; et l'énergie spécifique définie par la puissance de la vis/la quantité de production, et
le septième paramètre est au moins l'un des suivants : une fréquence de vibration mécanique du dispositif de traitement de résine (100, 101, 500) ; un nombre d'arrêts du dispositif de traitement de résine (100, 101, 500) dans les 24 heures ; un nombre d'arrêts du dispositif de traitement de résine (100, 101, 500) pendant 24 heures ou plus ; un temps de fonctionnement après le démontage et le nettoyage du dispositif de traitement de résine (100, 101, 500) ; un temps de fonctionnement cumulé pour chaque type de la résine ; un temps de fonctionnement cumulé pour chaque type d'une résine spécifique ; et un temps de fonctionnement cumulé pendant lequel la vis fonctionne avec une puissance égale ou supérieure à une valeur seuil.

12. Programme d'apprentissage automatique d'un dispositif d'apprentissage automatique qui détermine une condition de traitement d'un dispositif de traitement de résine (100, 101, 500), dans lequel
le dispositif de traitement de résine (100, 101, 500) comprend :

une unité de traitement de résine (2, 200) qui a une vis rotative et un récipient de traitement (25, 250) recouvrant la vis, et qui malaxe une résine alimentée et sort une résine malaxée ;

un alimentateur (1) configuré pour alimenter la résine à l'unité de traitement de résine (2, 200) ; et

un granulateur (8) qui, en aval de l'unité de traitement de résine (2, 200), granule la résine sortant de l'unité de traitement de résine (2, 200),

le programme d'apprentissage automatique amenant un ordinateur à fonctionner comme :

une partie d'acquisition d'état (420) qui acquiert une variable d'état comportant au moins une quantité physique liée à un état de granulation de la résine et au moins une condition de traitement d'un premier paramètre, d'un deuxième paramètre, d'un troisième paramètre, d'un quatrième paramètre, d'un cinquième paramètre, d'un sixième paramètre et d'un septième paramètre, le premier paramètre étant lié à la résine, le deuxième paramètre étant lié au alimentateur, le troisième paramètre étant lié à un état de fonctionnement de l'unité de traitement de résine, le quatrième paramètre étant lié à la résine malaxée, le cinquième paramètre étant lié à une température du dispositif de traitement de résine, le sixième paramètre étant lié au granulateur, et le septième paramètre étant lié à un état de fonctionnement du dispositif de traitement de résine ;

une partie de calcul de récompense (411) qui calcule une récompense pour un résultat de détermination de l'au moins une condition de traitement sur la base de la variable d'état ;

une partie de mise à jour (412) qui met à jour une fonction de détermination de l'au moins une condition de traitement à partir de la variable d'état sur la base de la récompense ; et

une partie de détermination (413) qui détermine, parmi le premier paramètre, le deuxième paramètre, le troisième paramètre, le quatrième paramètre, le cinquième paramètre, le sixième paramètre et le septième paramètre, au moins une condition de traitement dans laquelle la récompense est la plus obtenue en répétant la mise à jour de la fonction, et dans lequel

l'au moins une quantité physique est au moins l'une parmi la qualité du pétrissage et la qualité du granulé,

**caractérisé en ce que**

le troisième paramètre est au moins l'un des suivants : une quantité de production indiquant une quantité de traitement d'une matière première formant la résine par unité de temps ; une vitesse de rotation de la vis par unité de temps ; un degré d'ouverture de la porte prévue dans la partie centrale du récipient de traitement (25, 250) ; une pression à l'entrée de la pompe à engrenages (6) prévue en aval de l'unité de traitement de résine (2, 200) ; la puissance de la vis ; et l'énergie spécifique définie par la puissance de la vis/la quantité de production, et

le septième paramètre est au moins l'un des suivants : une fréquence de vibration mécanique du dispositif de traitement de résine (100, 101, 500) ; un nombre d'arrêts du dispositif de traitement de résine (100, 101, 500) dans les 24 heures ; un nombre d'arrêts du dispositif de traitement de résine (100, 101, 500) pendant 24 heures ou plus ; un temps de fonctionnement après le démontage et le nettoyage du dispositif de traitement de résine (100, 101, 500) ; un temps de fonctionnement cumulé pour chaque type de la résine ; un temps de fonctionnement cumulé pour chaque type d'une résine spécifique ; et un temps de fonctionnement cumulé pendant lequel la vis fonctionne avec une puissance égale ou supérieure à une valeur seuil.

# FIG.1

<u>100</u>

EP 3 988 270 B1

# FIG.2

EP 3 988 270 B1

# FIG.3

SERVER ⌐400

PROCESSOR ⌐410

| REWARD CALCULATION PORTION ⌐411 | UPDATE PORTION ⌐412 |
| DETERMINATION PORTION ⌐413 | LEARNING CONTROL PORTION ⌐414 |

COMMUNICATION PORTION ⌐420

NETWORK ~NT1

COMMUNICATION DEVICE ⌐300

| TRANSMITTER ⌐301 | RECEIVER ⌐302 |

NETWORK ~NT2

RESIN PROCESSING DEVICE ⌐500

COMMUNICATION PORTION ⌐110

⌐120

SENSOR PORTION ⌐130

INPUT PORTION ⌐140

| STATE OBSERVATION PORTION ⌐121 | PROCESSING EXECUTION PORTION ⌐122 |
| | INPUT DETERMINATION PORTION ⌐123 |

MEMORY ⌐150

# FIG.4

| MEDIUM CLASSIFICATION | RESIN (FIRST PARAMETER) | | | |
|---|---|---|---|---|
| SMALL CLASSIFICATION | BEFORE S/C RESIN PRESSURE | BEFORE DIE RESIN PRESSURE | BEFORE AND AFTER S/C | SCREEN SIZE |
| DESCRIPTION | RESIN PRESSURE AT INLET OF SCREEN CHANGER | RESIN PRESSURE AT INLET OF DIE PROCESSING PORTION | DIFFERENTIAL PRESSURE OF RESIN BEFORE AND AFTER SCREEN CHANGER | FINENESS OF MESH OF SCREEN CHANGER |
| LEARNABLE PARAMETER | O | O | O | |
| USER SETTING | | | | O |

| MEDIUM CLASSIFICATION | FEEDER (SECOND PARAMETER) | | | | | | | | | |
|---|---|---|---|---|---|---|---|---|---|---|
| SMALL CLASSIFICATION | RAW MATERIAL MOLECULAR WEIGHT DISTRIBUTION | RAW MATERIAL MI | RAW MATERIAL PARTICLE SIZE DISTRIBUTION | RAW MATERIAL TEMPERATURE | $O_2$ CONCENTRATION IN HOPPER | HOPPER $N_2$ FLOW RATE | DE $N_2$ FLOW RATE | GATE $N_2$ FLOW RATE | WE $N_2$ FLOW RATE | PRE-MIXING METHOD |
| DESCRIPTION | MEASUREMENT VALUE OF RATIO OF MOLECULAR WEIGHT OF EACH RAW MATERIAL | AMOUNT OF RESIN EXTRUDED PER 10 MINUTE FROM OPENING (NOZZLE) PROVIDED AT BOTTOM OF CYLINDRICAL CONTAINER AFTER CERTAIN AMOUNT OF SYNTHETIC RESIN IS HEATED AND PRESSURIZED AT PREDETERMINED TEMPERATURE IN CYLINDRICAL CONTAINER | MEASUREMENT VALUE OF RATIO OF PARTICLE SIZE OF EACH RAW MATERIAL | TEMPERATURE OF RAW MATERIAL (RESIN) TO BE CHARGED INTO RESIN PROCESSING UNIT | $O_2$ CONCENTRATION IN HOPPER | FLOW RATE OF $N_2$ SUPPLIED TO HOPPER | FLOW RATE OF $N_2$ SUPPLIED TO GAP BETWEEN PROCESS CONTAINER AND SCREW | FLOW RATE OF $N_2$ SUPPLIED TO GAP BETWEEN PROCESS CONTAINER AND GATE | FLOW RATE OF $N_2$ SUPPLIED TO GAP BETWEEN PROCESS CONTAINER AND SCREW | METHOD OF MIXING RAW MATERIAL AND ADDITIVE BEFORE BEING CHARGED INTO SCREW PORTION |
| LEARNABLE PARAMETER | | | | O | O | | | | | |
| USER SETTING | O | O | O | O | | | | | | O |

| MEDIUM CLASSIFICATION | OPERATION CONDITION OF KNEADING PROCESSING UNIT (THIRD PARAMETER) | | | | | |
|---|---|---|---|---|---|---|
| SMALL CLASSIFICATION | PRODUCTION AMOUNT | SCREW ROTATION SPEED | GATE OPENING DEGREE | PRESSURE AT GEAR PUMP INLET | SCREW POWER | SPECIFIC ENERGY |
| DESCRIPTION | PROCESSING AMOUNT OF RAW MATERIAL PER UNIT TIME | ROTATION SPEED OF SCREW PER UNIT TIME | NARROWING DEGREE OF MECHANISM THAT VARIABLY NARROWS RAW MATERIAL PASSAGE | PRESSURE ON SUCTION SIDE OF GEAR PUMP DOWNSTREAM OF EXTRUDER | ROTATIONAL TORQUE OF SCREW × ROTATION SPEED. ENERGY REQUIRED FOR PROCESSING OF RAW MATERIAL | SCREW POWER /PRODUCTION AMOUNT. ENERGY REQUIRED FOR PROCESSING OF RAW MATERIAL |
| LEARNABLE PARAMETER | O | O | O | O | O | O |
| USER SETTING | O | | | | | |

| MEDIUM CLASSIFICATION | KNEADED RESIN (FOURTH PARAMETER) | | | |
|---|---|---|---|---|
| SMALL CLASSIFICATION | GATE RESIN TEMPERATURE | RESIN TEMPERATURE AT GEAR PUMP INLET | RESIN TEMPERATURE AT GEAR PUMP OUTLET | BEFORE DIE RESIN TEMPERATURE |
| DESCRIPTION | MEASUREMENT VALUE OF RESIN TEMPERATURE AT GATE | MEASUREMENT VALUE OF RESIN TEMPERATURE AT GEAR PUMP INLET | RAW MATERIAL TEMPERATURE MEASURED AT GEAR PUMP OUTLET | MEASUREMENT VALUE OF RESIN TEMPERATURE ON UPSTREAM SIDE OF DIE PROCESSING PORTION |
| LEARNABLE PARAMETER | O | O | O | O |
| USER SETTING | | | | |

# EP 3 988 270 B1

# FIG.5

| MEDIUM CLASSIFICATION | DEVICE TEMPERATURE (FIFTH PARAMETER) | | | | | | |
|---|---|---|---|---|---|---|---|
| SMALL CLASSIFICATION | FIRST CHAMBER TEMPERATURE | SECOND CHAMBER TEMPERATURE | T/P TEMPERATURE | GEAR PUMP TEMPERATURE | SCREEN CHANGER TEMPERATURE | DIE HOLDER TEMPERATURE | HOT OIL TEMPERATURE |
| DESCRIPTION | METAL TEMPERATURE | METAL TEMPERATURE | METAL TEMPERATURE | METAL TEMPERATURE | METAL TEMPERATURE | METAL TEMPERATURE | TEMPERATURE OF HOT OIL FOR RAISING TEMPERATURE |
| LEARNABLE PARAMETER | ○ | ○ | ○ | ○ | ○ | ○ | ○ |
| USER SETTING | | | | | | | |

| MEDIUM CLASSIFICATION | PELLETIZER (SIXTH PARAMETER) | | | | | |
|---|---|---|---|---|---|---|
| SMALL CLASSIFICATION | START-UP SEQUENCE /TIMER SET | KNIFE ROTATION SPEED | KNIFE PRESSING FORCE | KNIFE RETURN PRESSING FORCE | KNIFE ALIGNMENT | PCW TEMPERATURE |
| DESCRIPTION | SELECTION OF STARTING METHOD | ROTATION SPEED OF KNIFE | FORCE FOR PRESSING KNIFE AGAINST DIE | FORCE FOR SEPARATING KNIFE FROM DIE | PARALLELISM OF KNIFE AND DIE | TEMPERATURE OF WATER USED TO EXTRUDE PELLET |
| LEARNABLE PARAMETER | ○ | ○ | ○ | ○ | | ○ |
| USER SETTING | | | | | | |

| MEDIUM CLASSIFICATION | OPERATING STATUS (SEVENTH PARAMETER) | | | | | | |
|---|---|---|---|---|---|---|---|
| SMALL CLASSIFICATION | MECHANICAL VIBRATION | THE NUMBER OF SHUTDOWNS WITHIN 24 HOURS | THE NUMBER OF SHUTDOWNS FOR 24 HOURS OR MORE | OPERATING TIME AFTER DISASSEMBLING AND CLEANING | TOTAL OPERATING TIME FOR EACH GRADE | TOTAL OPERATING TIME FOR HARD GRADE | OPERATING TIME OF SCREW WITH POWER EQUAL TO OR GREATER THAN THRESHOLD VALUE |
| DESCRIPTION | VIBRATION VALUE AT EACH PLACE OF RESIN KNEADER | THE NUMBER OF RELATIVELY SHORT MACHINE STOPS | THE NUMBER OF RELATIVELY LONG MACHINE STOPS | DITTO | ACCUMULATED TIME OF OPERATING TIME FOR EACH KIND OF RESIN | DITTO | DITTO |
| LEARNABLE PARAMETER | | ○ | ○ | ○ | ○ | ○ | ○ |
| USER SETTING | | ○ | ○ | ○ | ○ | ○ | ○ |

| MEDIUM CLASSIFICATION | GEAR PUMP (EIGHTH PARAMETER) | | |
|---|---|---|---|
| SMALL CLASSIFICATION | ROTATION SPEED | POWER | SPECIFIC ENERGY |
| DESCRIPTION | ROTATION SPEED OF GEAR PUMP ROTOR | POWER FOR ROTATING GEAR PUMP ROTOR | VALUE OBTAINED BY DIVIDING GEAR PUMP POWER BY PRODUCTION AMOUNT |
| LEARNABLE PARAMETER | ○ | ○ | ○ |
| USER SETTING | | | |

# FIG.6

| PHYSICAL QUANTITY (EVALUATION PARAMETER) | |
|---|---|
| MEDIUM CLASSIFICATION | SMALL CLASSIFICATION |
| KNEADING QUALITY | MI SHIFT |
| | GEL NUMBER |
| | STRENGTH (TENSILE, CHARPY, ETC.) |
| | DISPERSION OF FILLER |
| PELLET QUALITY | COLOR TONE YELLOW INDEX |
| | BLACK SPECIFICATION |
| | PELLET SHAPE |
| | TAIL |
| | LONG PELLET |
| | MINI-PELLET, |
| | CLUSTER |
| | FINE, |
| | PELLET ADHESION MOISTURE PERCENTAGE |

## FIG.7

START

↓ S1

ACQUIRE INPUT
VALUE OF PROCESSING
CONDITION

↓ S2

DETERMINE SET VALUE
FOR PROCESSING
CONDITION

↓ S3

EXECUTE PROCESSING

↓ S4

OBSERVE STATE VARIABLE

↓ S5

EVALUATE PHYSICAL QUANTITY

↓ S6

TARGET
PHYSICAL QUANTITY
HAS REACHED REFERENCE
VALUE?

— NO →

YES ↓ S7

OUTPUT PROCESSING CONDITION

↓

END

S8

TARGET
PHYSICAL QUANTITY
APPROACHES REFERENCE
VALUE?

— NO →

YES ↓ S9          S10

INCREASE REWARD     DECREASE REWARD

↓ S11

UPDATE ACTION
VALUE FUNCTION

# FIG.8

500A

RESIN PROCESSING DEVICE

120A

PROCESSOR

160

MACHINE LEARNING UNIT

161

REWARD
CALCULATION
PORTION

162

UPDATE
PORTION

163

DETERMINATION
PORTION

164

LEARNING
CONTROL
PORTION

170

PROCESSING EXECUTION UNIT

171

STATE
OBSERVATION
PORTION

172

PROCESSING
EXECUTION
PORTION

173

INPUT
DETERMINATION
PORTION

180

INPUT
PORTION

190

SENSOR
PORTION

**EP 3 988 270 B1**

## REFERENCES CITED IN THE DESCRIPTION

**Patent documents cited in the description**

- JP 2012051363 A
- EP 3640002 A1
- EP 2610041 A1
- JP 2020163783 A